# EUROPÄISCHE PATENTSCHRIFT

(11) **EP 3 435 482 B1**
(45) Veröffentlichungstag und Bekanntmachung des Hinweises auf die Patenterteilung: **15.05.2019**
(21) Anmeldenummer: 17183028.4
(22) Anmeldetag: 25.07.2017
(51) Int. Cl.: H01R 4/02, H01R 12/53, H01R 24/50

(54) **ANSCHLUSSVERBINDUNG MIT EINER KABELANORDNUNG UND EINER PLATTENANORDNUNG, SOWIE EIN VERFAHREN ZUM HERSTELLEN EINER SOLCHEN ANSCHLUSSVERBINDUNG**
CONNECTION PIECE WITH A CABLE ASSEMBLY AND A PLATE ASSEMBLY, METHOD FOR PRODUCING SUCH A CONNECTION PIECE
LIAISON DE CONNEXION COMPRENANT UN SYSTÈME DE CÂBLE ET UN SYSTÈME DE PLAQUE, PROCÉDÉ DE FABRICATION D'UNE TELLE LIAISON DE CONNEXION

(43) Veröffentlichungstag der Anmeldung: 30.01.2019
(73) Patentinhaber: MD Elektronik GmbH, 84478 Waldkraiburg (DE)
(72) Erfinder: Huber, Martin, 83119 Obing (DE); Hofmann, Robert, 83376 Truchtlaching (DE)
(74) Vertreter: Flach Bauer Stahl Patentanwälte Partnerschaft mbB

(56) Entgegenhaltungen:
- EP-A2- 1 154 512
- WO-A2-2006/067028
- US-A1- 2006 281 343

## Beschreibung

Die Erfindung betrifft eine Anschlussverbindung mit einer Kabelanordnung und einer Plattenanordnung, sowie ein Verfahren zum Herstellen einer solchen Anschlussverbindung.

Bei einer solchen Anschlussverbindung handelt es sich um eine Möglichkeit, wie ein Kabel, insbesondere ein Koaxialkabel mit einer Leiterplatte (Plattenanordnung) elektrisch und mechanisch effizient verbunden werden kann. Es kann auch von einer HSD-Anschlussverbindung (engl. High Speed Data) gesprochen werden, über die vorzugsweise LVDS-Signale (engl. Low Voltage Differential Signaling; dt. Niederspannung-Differentialsignalisierung), zu denen u.a. USB-Signale oder Bildschirmsignale gehören, übertragen werden.

Bei immer kleineren Strukturen ist dabei eine mögliche Anbindung von Einzel- bzw. Mehrfachadern eines Kabels an einen Stecker, insbesondere eine Platine, ein zentrales Thema. Bei immer höher werdenden Datenraten stößt man immer stärker an die Grenzen, was in einem Standard-Lötprozess in Handfertigung prozesssicher realisiert werden kann. Bei diesen höheren Datenraten kommt es auch stärker darauf an, dass elektrisch gesehen der Abstand der Leiterbahnen im Verhältnis zur Einzelader möglichst symmetrisch bzw. mit geringem Abstand ausgeführt werden kann.

Dabei sind Steckverbinder in unterschiedlichen Ausführungsvarianten bekannt. Einige dieser Steckverbinder eignen sich zum Anschluss auf Platinen, also Leiterplatten. Diese sind meistens in einem 90°-Winkel ausgeführt, so dass das Anschlusskabel parallel zur Leiterplatte geführt werden kann. In diesem Zusammenhang wird auf die DE 20 2014 008 843 U1 verwiesen, die eine Leiterplatte und einen entsprechenden Steckverbinder zeigt. Der Steckverbinder wird dabei mit der Leiterplatte verlötet und eignet sich zum Anschluss an ein Verbindungskabel.

Die WO 2006/067028 A2 zeigt eine Leiterplattenanordnung mit einer Leiterplatte, die mehrere Lagen umfasst. Die Leiterplatte umfasst sowohl innere Leiterbahnen als auch äußere Leiterbahnen. An der Stirnseite der Leiterplatte sind seitliche Öffnungen angebracht. Nach dem Ein- bzw. Aufbringen von Lotpaste können dort hineingesteckte Anschlusspins bzw. Anschlussdrähte eines Jumpers zusammen mit anderen Bauteilen auf der Leiterplatte in einem Reflow-Verfahren verlötet werden.

Auch aus der US 2013/0231011 A1 ist eine Anschlussverbindung zu entnehmen, über die die Innenleiter mehrerer Kabel mit verschiedenen Leiterplatten verlötet werden. Die Kabel sind dabei nebeneinander und übereinander angeordnet und weisen keinen Außenleiter auf. Innenleiter, die nebeneinander angeordnet sind, sind auf einer ersten Seite einer Leiterplatte mit entsprechenden Anschlusspads verlötet, wohingegen Innenleiter von darunter bzw. darüber liegenden Kabeln mit einer zweiten gegenüberliegenden Seite dieser Leiterplatte verlötet sind. Insgesamt gibt es zwei Leiterplatten, wobei beide Seiten dieser Leiterplatten mit entsprechenden Kabeln verlötet sind und wobei beide Leiterplatten durch ein Befestigungselement voneinander getrennt sind.

Nachteilig an der US 2013/0231011 A1 ist, dass das Anlöten der Innenleiter der Kabel an die entsprechende Ober- bzw. Unterseite der jeweiligen Leiterplatte und das Herstellen der Anschlussverbindung nur schwer automatisierbar ist und dass die einzelnen Innenleiter ungeschirmt angeordnet sind.

Es ist daher die Aufgabe der hier vorliegenden Erfindung, eine Anschlussverbindung mit einer Kabelanordnung und einer Plattenanordnung zu schaffen, die es erlaubt, dass die einzelnen Kabel, insbesondere die Innenleiter auf engstem Bauraum angeschlossen werden können. Dabei soll ein automatisierter Verarbeitungsprozess realisierbar sein. Die Anschlussverbindung soll dabei kostengünstig sein und dennoch gleich gute oder sogar bessere elektrische Eigenschaften aufweisen als Anschlussverbindungen aus dem Stand der Technik.

Diese Aufgabe wird durch die Anschlussverbindung gemäß dem unabhängigen Anspruch 1 und durch ein Verfahren zur Herstellung dieser Anschlussverbindung gemäß dem Anspruch 15 gelöst. In den Ansprüchen 2 bis 14 sind vorteilhafte Weiterbildungen der Anschlussverbindung gezeigt.

Die erfindungsgemäße Anschlussverbindung umfasst eine Kabelanordnung und (genau) eine Plattenanordnung (z.B. Leiterplatte). Die Plattenanordnung umfasst zumindest drei in Längsrichtung aufeinander gestapelte Lagen, wobei eine Zwischenlage zwischen einer ersten Außenlage und einer zweiten Außenlage angeordnet ist, und wobei alle drei Lagen direkt oder mittelbar miteinander verbunden sind. Bei einer direkten Verbindung gibt es keine weiteren zusätzlichen Lagen zwischen der jeweiligen Außenlage und der Zwischenlage. Bei einer mittelbaren Verbindung können dagegen noch eine oder mehrere zusätzliche Lagen eingebracht sein. Unter dem Wortlaut "miteinander verbunden" wird eine mechanische Verbindung, insbesondere durch Verkleben und/oder Verpressen verstanden. Die einzelnen Lagen können dabei insbesondere nur unter Zerstörung der Plattenanordnung wieder voneinander gelöst werden. Die erste Außenlage und/oder die zweite Außenlage ist elektrisch leitfähig, wohingegen die Zwischenlage aus einem Dielektrikum besteht bzw. ein solches umfasst. Beide Außenlagen sind grundsätzlich galvanisch voneinander getrennt, können allerdings durch entsprechende Durchkontaktierungen (VIAs; Vertical Interconnect Access) miteinander elektrisch verbunden werden.

Die Plattenanordnung umfasst außerdem zwischen der ersten Außenlage und der zweiten Außenlage eine Ausnehmung, wodurch ein Kabelaufnahmeraum an einem ersten Seitenrand bzw. Seitenrandbereich der Plattenanordnung gebildet ist. Zumindest eine erste Innenleiterkontaktieröffnung durchsetzt die erste Außenlage und/oder die zweite Außenlage und mündet in den Kabelaufnahmeraum. Vorzugsweise werden beide Außenlagen durchsetzt, wobei zumindest diejenige Außenlage durchsetzt sein sollte, die aus einem elektrisch leitfähigen Material besteht.

Die Kabelanordnung umfasst zumindest ein erstes Kabel, wobei das erste Kabel einen elektrisch leitfähigen Innenleiter aufweist. Der Innenleiter des zumindest einen ersten Kabels ist über den ersten Seitenrand bzw. Seitenrandbereich in den ersten Kabelaufnahmeraum eingeführt und in Draufsicht auf die erste oder zweite Außenlage unter der zumindest einen ersten Innenleiterkontaktieröffnung angeordnet. Dies bedeutet, dass der Innenleiter des zumindest einen ersten Kabels in Längsrichtung versetzt zu der zumindest einen ersten Innenleiterkontaktieröffnung angeordnet ist. Der Innenleiter des zumindest einen ersten Kabels ist über eine erste Innenleiterlötverbindung zumindest im Bereich der ersten Innenleiterkontaktieröffnung mit einem ersten Innenleiteranschlussbereich der ersten und/oder zweiten Außenlage elektrisch leitfähig verlötet.

Erfindungsgemäß weist die Kabelanordnung der Anschlussverbindung noch eine Kabelsammel- und Ausrichteinrichtung auf, die einen Grundkörper umfasst. Die Kabelsammel- und Ausrichteinrichtung besteht dabei aus einem Kunststoff oder umfasst einen solchen. Die Kabelsammel- und Ausrichteinrichtung ist unverschiebbar an dem ersten Kabel bzw. an allen Kabeln angeordnet. Sie dient dazu, dass die einzelnen Kabel in einer bestimmten Ausricht- bzw. Winkellage zueinander stehen. Die Kabelsammel- und Ausrichteinrichtung umfasst zumindest eine Befestigungseinrichtung, die an dem Grundkörper ausgebildet ist, wobei diese dazu dient, die Kabelsammel- und Ausrichteinrichtung derart an der Plattenanordnung zu befestigen, dass das zumindest eine Kabel bzw. alle Kabel lageunveränderlich in dem Kabelaufnahmeraum angeordnet sind. Dadurch, dass die einzelnen Kabel eine bestimmte Ausricht- und Winkellage bei Einsatz einer solchen Kabelsammel- und Ausrichteinrichtung einnehmen, können eine Vielzahl von nebeneinander angeordneten Kabeln gleichzeitig in den Kabelaufnahmeraum eingeschoben werden. Die Kabelsammel- und Ausrichteinrichtung dient mit ihrer Befestigungseinrichtung auch als Zugentlastung, sodass bei Zugkräften auf die Kabel die einzelnen Lötverbindungen nicht beschädigt werden.

Es ist besonders vorteilhaft, dass die Plattenanordnung, bei welcher es sich insbesondere um eine Leiterplatte (z.B. FR4) handelt, in ihrer dielektrischen Schicht, also in der Zwischenschicht, eine Ausnehmung aufweist, in die zumindest der Innenleiter des Kabels eingeführt ist. Dieser Innenleiter ist dabei besonders bevorzugt mit einer oder beiden Außenlagen elektrisch leitfähig verlötet, wodurch eine optimierte HF-Anbindung mit einem geringen Impedanz-Sprung erreicht wird. Die Leiterplatte kann aus Standardlaminat-Platinen-Substraten hergestellt werden, was eine besonders günstige Produktion erlaubt. Für den Fall, dass beide Außenlagen elektrisch leitfähig sind, findet außerdem noch eine gute elektrische Abschirmung des freigelegten Innenleiters statt.

In einer bevorzugten Ausführungsform der Anschlussverbindung ist die erste Innenleiterlötverbindung aus einem erhitzten Innenleiterlotdepot gebildet, welches beispielsweise in der zumindest einen ersten Innenleiterkontaktieröffnung und/oder an dem Innenleiter des zumindest einen ersten Kabels unterhalb der zumindest einen ersten Innenleiterkontaktieröffnung angeordnet ist. Das Innenleiterlotdepot kann sehr einfach mittels einer Dispenser-Einheit in die Innenleiterkontaktieröffnung eingebracht werden, wobei es durch einen Lötvorgang schmelzflüssig gemacht werden kann, woraufhin es sich mit dem Innenleiter verbindet. Der Lötvorgang kann durch eine normale Lötspitze oder einen induktiven Lötvorgang erreicht werden.

In einer weiteren bevorzugten Ausführungsform umfasst das erste Kabel noch einen elektrisch leitfähigen Außenleiter, der vom Innenleiter durch ein Dielektrikum galvanisch getrennt ist. Die Plattenanordnung umfasst noch eine erste Außenleiterkontaktieröffnung, die die erste Außenlage und/oder die zweite Außenlage durchsetzt und ebenfalls in den Kabelaufnahmeraum mündet. Die erste Außenleiterkontaktieröffnung ist dabei näher an dem ersten Seitenrand bzw. Seitenrandbereich angeordnet als die erste Innenleiterkontaktieröffnung. Der Außenleiter des zumindest einen ersten Kabels ist an dem ersten Seitenrand in dem Kabelaufnahmeraum eingeführt und in Draufsicht auf die erste oder zweite Außenlage unter der zumindest einen ersten Außenleiterkontaktieröffnung angeordnet. Dies bedeutet, dass der Außenleiter des zumindest einen ersten Kabels in Längsrichtung versetzt zu der zumindest einen ersten Außenleiterkontaktieröffnung angeordnet ist. Der Außenleiter des zumindest einen ersten Kabels ist über eine erste Außenleiterlötverbindung zumindest im Bereich der ersten Außenleiterkontaktieröffnung mit einem Außenleiteranschlussbereich der ersten und/oder der zweiten Außenlage elektrisch leitfähig verlötet. Der erste Innenleiteranschlussbereich ist galvanisch von dem ersten Außenleiteranschlussbereich getrennt. Besonders vorteilhaft ist dabei, dass auch der Außenleiter des zumindest einen ersten Kabels genauso einfach mit der Plattenanordnung verbunden werden kann wie der Innenleiter. Dadurch können Koaxialkabel besonders einfach in einer solchen Anschlussverbindung mit einer Plattenanordnung, also mit einer Leiterplatte, elektrisch leitend verbunden werden.

In einer anderen Ausführungsform umfasst die Kabelanordnung noch zumindest ein zweites Kabel mit einem elektrisch leitfähigen Innenleiter. Die zumindest beiden Kabel sind dabei nebeneinander angeordnet. Insbesondere liegen alle Kabel der Kabelanordnung in dem Kabelaufnahmeraum in einer Ebene, die wiederum parallel zur Plattenanordnung bzw. den einzelnen Lagen der Plattenanordnung verläuft. Eine zweite Innenleiterkontaktieröffnung ist entsprechend der ersten Innenleiterkontaktieröffnung angeordnet, wohingegen sich der Innenleiter des zumindest einen zweiten Kabels in Draufsicht auf die erste oder zweite Außenlage unter der zumindest einen zweiten Innenleiterkontaktieröffnung befindet. Dies bedeutet, dass der Innenleiter des zumindest einen zweiten Kabels in Längsrichtung versetzt zu der zumindest einen zweiten Innenleiterkontaktieröffnung angeordnet ist. Eine zweite Innenleiterlötverbindung stellt eine galvanische Verbindung zwischen dem Innenleiter des zweiten Kabels und einem zweiten Innenleiteranschlussbereich der ersten und/oder zweiten Außenlage sicher. Die beiden Innenleiteranschlüsse der beiden Kabel sind dabei galvanisch voneinander getrennt. Dies wird insbesondere dadurch erreicht, dass die beiden Innenleiter entweder mit verschiedenen Außenlagen verbunden sind oder mit der bzw. den gleichen Außenlagen, wobei die Außenlage bzw. die Außenlagen in verschiedene Innenleiteranschlussbereiche untergliedert ist bzw. sind, die wiederum galvanisch voneinander getrennt sind. Bei dem Einsatz einer Leiterplatte sind die einzelnen Innenleiter der zumindest zwei Kabel mit unterschiedlichen Signalleitungen auf der Leiterplatte galvanisch verlötet.

Besonders bevorzugt weist auch das zweite Kabel einen entsprechend elektrisch leitfähigen Außenleiter auf, der wie der Außenleiter des ersten Kabels mit der Plattenanordnung verlötet ist.

Eine Plattenanordnung dient zum Herstellen einer Anschlussverbindung und umfasst, wie bereits erläutert, drei in Längsrichtung aufeinander gestapelte Lagen, die mechanisch fest miteinander verbunden sind, wobei eine Zwischenlage zwischen einer ersten und einer zweiten Außenlage angeordnet ist. Die erste Außenlage und die zweite Außenlage sind elektrisch leitfähig und die Zwischenlage umfasst ein dielektrisches Material, wobei die Plattenanordnung zwischen beiden Außenlagen eine Ausnehmung aufweist, wodurch ein Kabelaufnahmeraum gebildet ist. Zumindest eine erste Innenleiterkontaktieröffnung durchsetzt dabei die erste Außenlage und/oder die zweite Außenlage und mündet in den Kabelaufnahmeraum. Zumindest ein erstes Innenleiterlotdepot ist dabei in der ersten Innenleiterkontaktieröffnung angeordnet. Eine solche Plattenanordnung ist besonders vorteilhaft, weil das erste Innenleiterlotdepot sehr einfach aufgebracht werden kann und eine zielgerichtete Verlötung zwischen der ersten bzw. zweiten Außenlage und dem Innenleiter des anzuschließenden Kabels erlaubt.

Das erfindungsgemäße Verfahren zur Herstellung einer solchen Anschlussverbindung umfasst verschiedene Verfahrensschritte. In einem ersten Verfahrensschritt wird eine Plattenanordnung hergestellt, die zumindest drei in Längsrichtung aufeinander gestapelte Lagen umfasst, wobei eine dielektrische Zwischenlage zwischen einer ersten bzw. einer zweiten Außenlage vorgesehen ist. Die erste und/oder zweite Außenlage ist dabei elektrisch leitfähig. Eine erste Ausnehmung ist zwischen den beiden Außenlagen eingebracht, wodurch ein Kabelaufnahmeraum an einem ersten Seitenrand bzw. Seitenrandbereich der Plattenanordnung gebildet ist.

In einem zweiten Verfahrensschritt wird zumindest eine erste Innenleiterkontaktieröffnung in die Plattenanordnung eingebracht, wobei diese die erste Außenlage und/oder die zweite Außenlage durchsetzt und in den Kabelaufnahmeraum mündet. Grundsätzlich kann dieser Verfahrensschritt auch vor dem Herstellen der Ausnehmung erfolgen.

In einem dritten Verfahrensschritt wird zumindest der Innenleiter (gegebenenfalls auch der Außenleiter) des zumindest einen ersten Kabels der Kabelanordnung freigelegt. Dieser Schritt kann natürlich auch vor dem ersten bzw. zweiten Verfahrensschritt ausgeführt werden.

Es wird weiterhin eine Kabelsammel- und Ausrichteinrichtung verwendet, die aus einem Kunststoff besteht oder einen solchen umfasst und einen Grundköper aufweist. Es erfolgt ein unverschiebliches Anordnen der Kabelsammel- und Ausrichteinrichtung an dem zumindest einen ersten Kabel, wobei die Kabelsammel- und Ausrichteinrichtung weiterhin eine Befestigungseinrichtung umfasst, die an dem Grundkörper ausgebildet ist.

In einem vierten Verfahrensschritt wird zumindest ein erstes Innenleiterlotdepot in die Innenleiterkontaktieröffnung eingebracht und/oder an den freigelegten Innenleiter des zumindest einen ersten Kabels angebracht.

In einem fünften Verfahrensschritt wird der Innenleiter des zumindest einen ersten Kabels an dem ersten Seitenrand in den Kabelaufnahmeraum eingeführt, so dass der Innenleiter des zumindest einen ersten Kabels in Draufsicht auf die erste oder zweiten Außenlage unter der zumindest einen ersten Innenleiterkontaktieröffnung angeordnet ist. Die Befestigungseinrichtung ist dabei dazu ausgebildet ist, die Kabelsammel- und Ausrichteinrichtung derart an der Plattenanordnung zu befestigen, dass das zumindest eine erste Kabel der Kabelanordnung lageunveränderlich in dem Kabelaufnahmeraum angeordnet ist.

In einem sechsten Verfahrensschritt wird das zumindest eine erste Innenleiterlotdepot erhitzt, bis dieses schmelzflüssig ist und den Innenleiter des zumindest einen ersten Kabels über eine erste Innenleiterlötverbindung zumindest im Bereich der ersten Innenleiterkontaktieröffnung mit einem ersten Innenleiteranschlussbereich der ersten und/oder zweiten Außenlage elektrisch leitfähig verbindet. Besonders vorteilhaft hieran ist, dass das zumindest eine erste Innenleiterlotdepot, welches in die Innenleiterkontaktieröffnung eingebracht wird, zu jedem Zeitpunkt in den Herstellungsprozess eingebracht werden kann. Dies bedeutet, dass die entsprechende Plattenanordnung bereits lange vor Herstellung der Anschlussverbindung vorbereitet werden kann. Das Verfahren ist dabei vollständig automatisiert durchführbar, was eine erhöhte Stückzahl bei niedrigeren Kosten und besseren elektrischen Eigenschaften garantiert.

Verschiedene Ausführungsbeispiele der Erfindung werden nachfolgend unter Bezugnahme auf die Zeichnungen beispielhaft beschrieben. Gleiche Gegenstände weisen dieselben Bezugszeichen auf. Die entsprechenden Figuren der Zeichnungen zeigen im Einzelnen:
Figuren 1A und 1B:
   einen beispielhaften Aufbau einer Kabelanordnung mit einem Koaxialkabel und z.B. einem HSD-Kabel;
Figuren 2A und 2B:
   verschiedene Schritte, die erläutern, wie die Kabelanordnung in Form eines Koaxialkabels vorbereitet wird, insbesondere wie der Innen- und Außenleiter zur Herstellung einer Anschlussverbindung beschaffen sein müssen;
Figuren 3A, 3E:
   eine vereinfachte Schnittdarstellung durch verschiedene Ausführungsbeispiele einer Plattenanordnung, die einen Innenleiter eines Kabels kontaktieren kann;
Figuren 3B, 3C, 3D:
   vereinfachte räumliche Darstellungen der Plattenanordnung;
Figuren 4A bis 4D:
   teilweise geschnittene Darstellungen verschiedener Ausführungsbeispiele durch eine erfindungsgemäße Anschlussverbindung mit der Kabelanordnung und der Plattenanordnung;
Figuren 4E, 4F:
   Draufsichten auf verschiedene Ausführungsbeispiele der erfindungsgemäßen Anschlussverbindung, wobei diese den Innenleiter eines oder zweier Kabel kontaktiert;

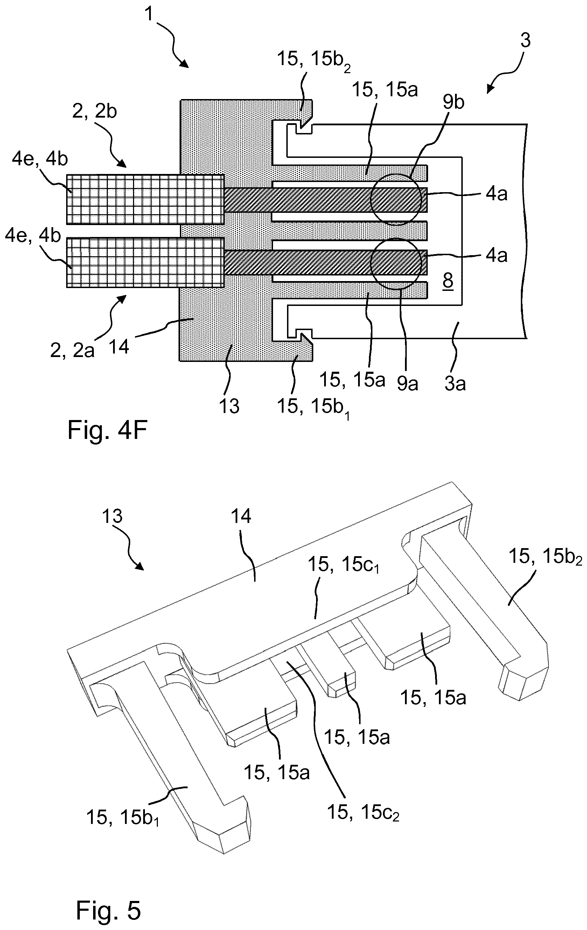

Figur 5: eine räumliche Darstellung einer Kabelsammel- und Ausrichteinrichtung der Kabelanordnung;
Figuren 6A bis 6C:
   verschiedene räumliche Darstellungen der Anschlussverbindung;

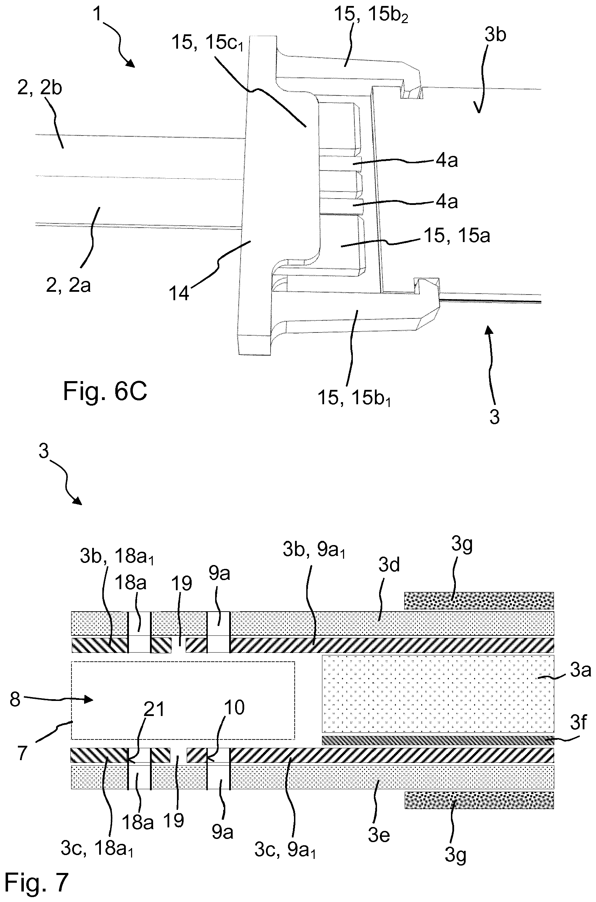

Figur 7: eine vereinfachte Schnittdarstellung eines weiteren Ausführungsbeispiels der Plattenanordnung, die sowohl einen Innenleiter als auch einen Außenleiter eines Kabels kontaktieren kann;
Figuren 8A bis 8C:
   teilweise geschnittene Darstellungen verschiedener Ausführungsbeispiele durch eine erfindungsgemäße Anschlussverbindung, wobei die Anschlussverbindung sowohl zum Kontaktieren des Innenleiters des Kabels als auch zum Kontaktieren des Außenleiters des Kabels dient;
Figur 8D: eine Draufsicht auf ein Ausführungsbeispiel der erfindungsgemäßen Anschlussverbindung, die zum Kontaktieren der Innenleiter und Außenleiter mehrerer Kabel dient; und
Figur 9: ein beispielhaftes Ablaufdiagramm, das ein erfindungsgemäßes Verfahren zum Herstellen der Anschlussverbindung zeigt.

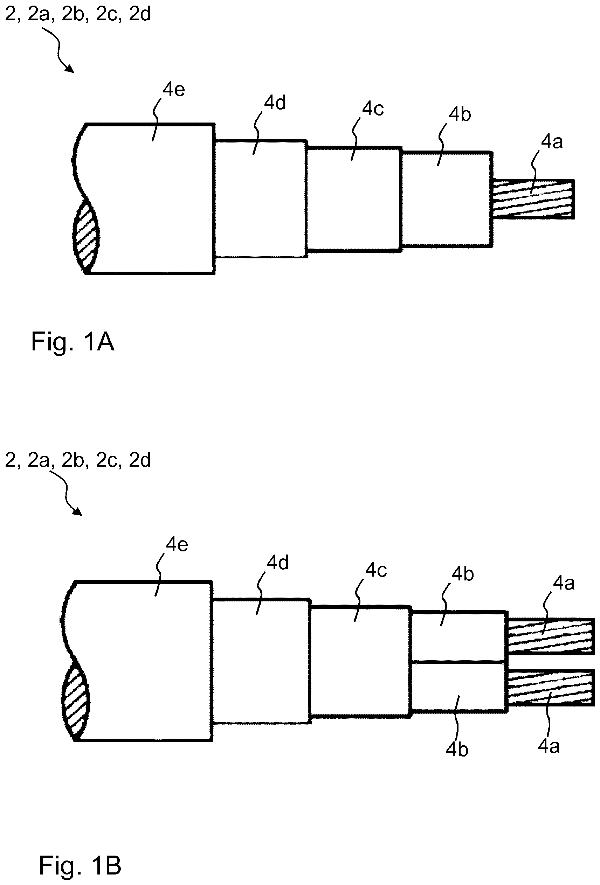

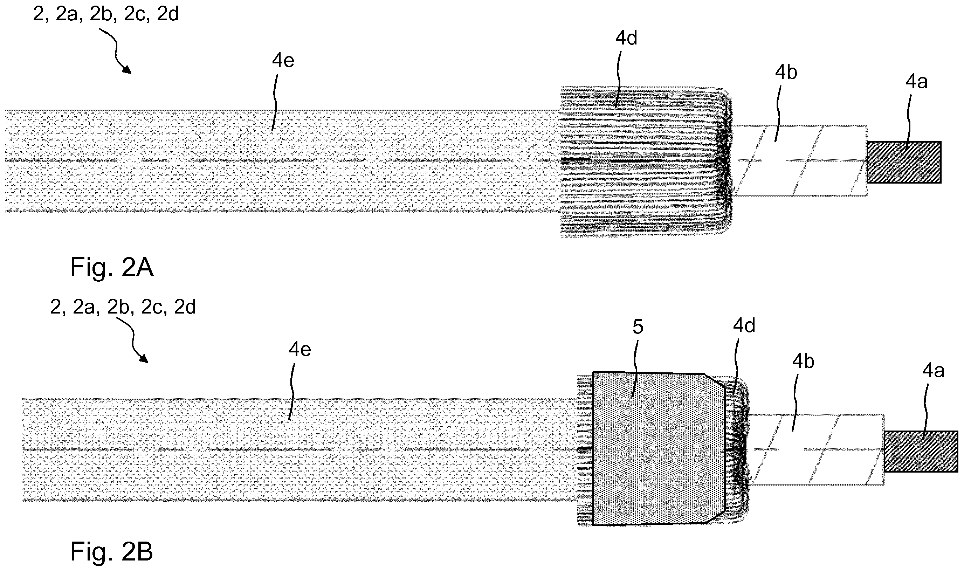

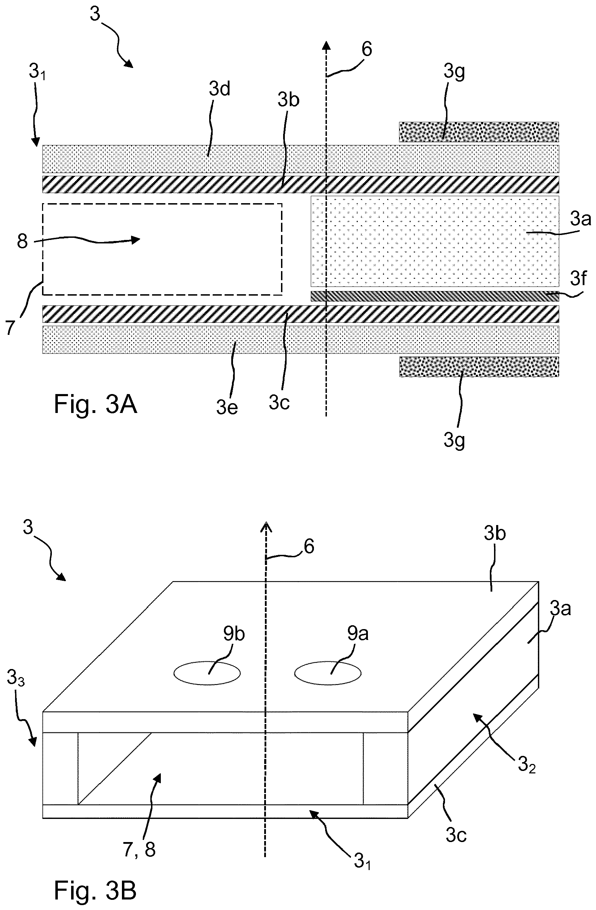

Nachfolgend wird beschrieben wie eine erfindungsgemäße Anschlussverbindung 1 zwischen einer Kabelanordnung 2 und einer Plattenanordnung 3 hergestellt werden kann. Verschiedene Ausführungsformen der Kabelanordnung 2 sind u.a. in den Figuren 1A, 1B, 2A und 2B dargestellt, wohingegen unterschiedliche Ausführungsbeispiele der Plattenanordnung 3 in den Figuren 3A bis 3E dargestellt sind.

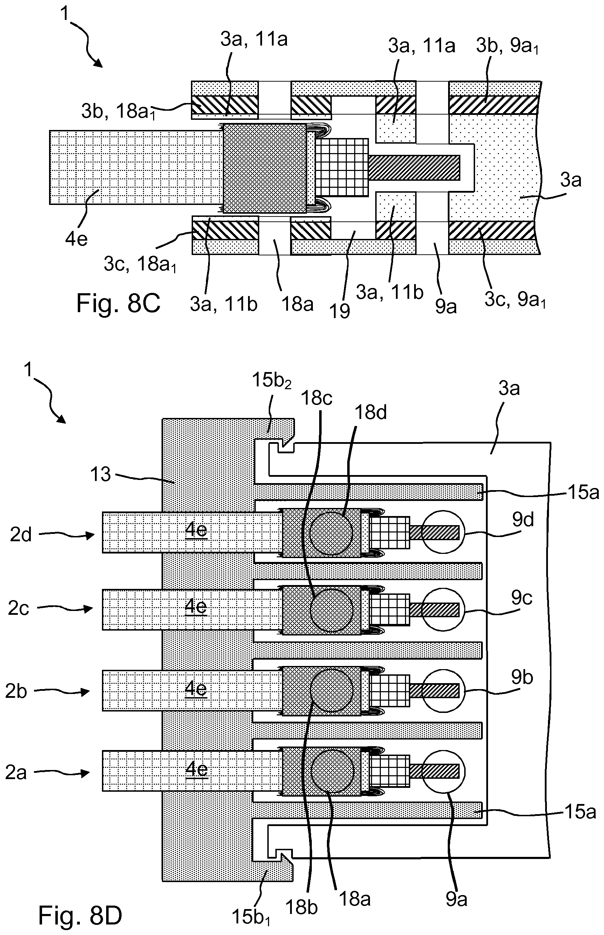

Die Figuren 1A und 1B zeigen verschiedene Ausführungsbeispiele der Kabelanordnung 2. Diese umfasst zumindest ein erstes Kabel 2a, 2b, 2c, 2d. Das erste Kabel 2a ist vorzugsweise geschirmt, um einerseits die Störfestigkeit zu erhöhen und andererseits die Störemissionen zu verringern. In Figur 1A ist das (geschirmte) erste Kabel 2a der Kabelanordnung 2 in Form einer Koaxialleitung dargestellt. Diese umfasst einen Innenleiter 4a, der aus einem elektrisch leitfähigen Material wie z.B. Kupfer besteht oder ein solches Material umfasst. Der Innenleiter 4a des ersten Kabels 2a ist von einem Dielektrikum 4b umgeben, welches aus einem elektrischen Isolator, insbesondere einem (elastischen) Kunststoff besteht. Das Dielektrikum 4b kann optional noch von einer Schirmfolie 4c umgeben sein, die vorzugsweise ein dielektrisches Material, insbesondere eine Kunststofffolie (z.B. PET-Folie) umfasst, auf die ein Metall aufgedampft bzw. aufgesputtert wurde. Die Schichtdicke dieses Metalls, bei dem es sich beispielsweise um Aluminium handeln kann, beträgt vorzugsweise 10 µm bis 20 µm. Auf diese optionale Schirmfolie 4c ist noch Außenleiter 4d aufgebracht. Dieser umfasst insbesondere Schirmdrähte, die auch als Schirmdrahtgeflecht bezeichnet werden können. Diese Schirmdrähte bestehen aus einem Metall und sind elektrisch leitfähig. Der Einsatz eines Außenleiters 4d ist zwar vorteilhaft aber nicht zwingend. Um den Außenleiter 4d herum ist noch ein Außenmantel 4e angeordnet, der vorzugsweise aus einem (elastischen) Dielektrikum wie Kunststoff besteht. Insgesamt kann es hiervon mehrere Kabel 2a, 2b, 2c, 2d usw. geben, wie diese beispielsweise in Figur 8D gezeigt sind, auf die später noch Bezug genommen wird. Jedes dieser Kabel 2a, 2b, 2c, 2d umfasst zumindest den Innenleiter 4a, das den Innenleiter 4a umgebende Dielektrikum 4b, den Außenleiter 4d und einen Außenmantel 4e.

Die Kabelanordnung 2 aus Figur 1A kann auch ein UTP-Kabel (engl. Unshielded Twisted Pair) umfassen. In diesem Fall werden die Schirmfolie 4c und der Außenleiter 4d weggelassen und der Außenmantel 4e ist lediglich optional vorgesehen. Bei einer USB-Verbindung kann die Anbindung des Kabels nämlich auch per UTP-Einzelader erfolgen.

Mehrere Kabel 2a, 2b, 2c, 2d können sich dabei die Schirmfolie 4c, den Außenleiter 4d und den Außenmantel 4e teilen. Ein solcher Aufbau der Kabelanordnung 2 ist in Figur 1B gezeigt.

Figur 1B zeigt dabei eine Kabelanordnung 2 mit mehreren Kabeln 2a, 2b, die ein HSD-Kabel bilden. Die Kabelanordnung 2 aus Figur 1B kann auch ein STP-Kabel (engl. Shielded Twisted Pair) oder ein SPP-Kabel (engl. Shielded Parallel Pair) oder ein SPQ-Kabel (engl. Shielded Parallel Quad) darstellen. Bei einem SPP-Kabel und einem SPQ-Kabel liegen die Innenleiter 4a nicht verdreht ("getwisted") unter der Schirmfolie 4c, sondern parallel nebeneinander. Die Kabelanordnung 2 ist daher nicht auf ein Koaxialkabel oder ein HSD-Kabel beschränkt. Jedes dieser Kabel 2a, 2b umfasst einen Innenleiter 4a und ein den Innenleiter 4a umgebendes Dielektrikum 4b. Im Unterschied zu Figur 1A umgibt hier eine (optionale) gemeinsame Schirmfolie 4c die Dielektrika 4b beider Kabel 2a, 2b. Um diese gemeinsame Schirmfolie 4c herum ist ein gemeinsamer Außenleiter 4d gewickelt, der wiederum von einem gemeinsamen Außenmantel 4e umgeben ist. Ein solcher Aufbau erlaubt einen höheren Datendurchsatz, insbesondere wenn ein differentielles Signal wie beispielsweise LVDS (engl. low voltage differential signalling) verwendet wird.

Grundsätzlich könnte das Kabel 2a, 2b, 2c, 2d auch nur den Innenleiter 4a und den Außenmantel 4e umfassen, welcher den Innenleiter 4a umgibt.

Wie einleitend erwähnt, ist es das Ziel dieser Erfindung, eine Anschlussverbindung 1 und ein entsprechendes Verfahren zum Herstellen dieser Anschlussverbindung 1 zu schaffen, durch die eine Kabelanordnung 2 mit einem oder mehreren Kabeln 2a, 2b, 2c, 2d möglichst vollautomatisch mit einer Plattenanordnung 3 verbunden werden kann. Hierzu müssen bestimmte Schichten der Kabel 2a, 2b, 2c, 2d freigelegt werden, die unterschiedliche Anschlussbereiche der Plattenanordnung 3 elektrisch kontaktieren.

Dieser Sachverhalt wird im Hinblick auf die Figuren 2A und 2B genauer erläutert. Figur 2A zeigt ein Kabel 2a, 2b, 2c, 2d der Kabelanordnung 2 in Form eines Koaxialkabels, wie dieses bereits bezüglich seines Aufbaus in Figur 1A beschrieben wurde, worauf hiermit verwiesen wird. Um mit diesem Kabel 2a, 2b, 2c, 2d die Anschlussverbindung 1 herstellen zu können, werden zumindest einzelne Schichten 4a, 4b, 4c, 4d, 4e auf eine unterschiedliche Länge eingeschnitten und abgezogen. Dadurch kommen zumindest der Innenleiter 4a, das Dielektrikum 4b und der Außenleiter 4d mit seinem Schirmdrahtgeflecht zum Vorschein. Die Schirmdrähte des Außenleiters 4d werden nach hinten, also weg von dem freigelegten Innenleiter 4a umgestülpt, also zurück- bzw. umgeklappt und optional gekürzt (z.B. mittels eines Lasers oder eines Messers). Das Dielektrikum 4b steht ebenfalls um eine bestimmte Länge von dem Außenleiter 4d hervor. Selbiges gilt für den Innenleiter 4a bezogen auf das Dielektrikum 4b. Eine Schirmfolie 4c ist nicht vorhanden bzw. bereits vollständig abgezogen.

In Figur 2B ist noch eine Metallfolie 5 gezeigt, die den Außenleiter 4d und damit insbesondere das Schirmgeflecht bzw. den überwiegenden Teil des freigelegten Schirmgeflechts des Außenleiters 4d umgibt bzw. um dieses herum gewickelt ist. Diese Metallfolie 5 stellt sicher, dass die einzelnen Schirmdrähte während der Herstellung der Anschlussverbindung 1 und auch danach ortsfest angeordnet bleiben und keine unerwünschte elektrische Kontaktierung stattfindet (z.B. zum Innenleiter 4a eines Kabels 2a, 2b, 2c, 2d).

Der Innenleiter 4a zumindest eines Kabels 2a, 2b, 2c, 2d besteht aus einer Litze, wobei die einzelnen Drähte dieser Litze vorzugsweise in einem Lötbad miteinander verlötet sind, sodass diese nicht von den restlichen Drähten, die den eigentlichen Innenleiter 4a bilden, abstehen und unerwünschte elektrische Kontaktierungen auslösen.

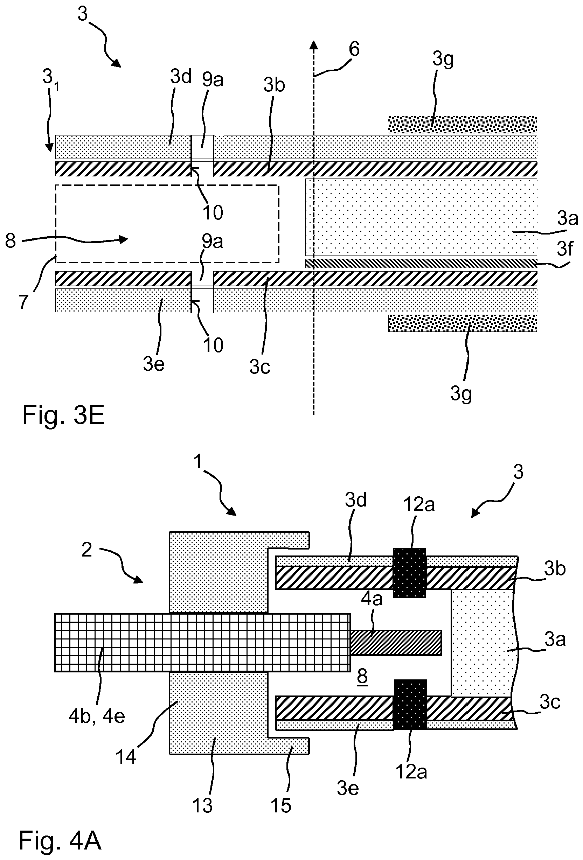

Zur Herstellung der erfindungsgemäßen Anschlussverbindung 1 wird die Kabelanordnung 2 mit der Plattenanordnung 3 verbunden. Eine vereinfachte (Längs-)Schnittdarstellung durch die Plattenanordnung 3 ist beispielsweise den Figuren 3A und 3E zu entnehmen. Bei der Plattenanordnung 3 handelt es sich insbesondere um eine Leiterplatte bzw. Leiterplatine, auf welcher Schaltungsträger in Form von Chips angeordnet, insbesondere verlötet sind. Die Plattenanordnung 3 umfasst vorzugsweise mindestens zwei Metalllagen, was bedeutet, dass Leiterbahnen bzw. die Schaltungsträger auf beiden Seiten der Leiterplatte verlaufen bzw. montierbar sind.

Die Plattenanordnung 3 umfasst zumindest drei in Längsrichtung 6 aufeinander gestapelte Lagen 3a, 3b, 3c. Eine Zwischenlage 3a ist dabei zwischen einer ersten Außenlage 3b und einer zweiten Außenlage 3c angeordnet. Alle drei Lagen 3a, 3b, 3c sind direkt oder mittelbar miteinander verbunden, also insbesondere verklebt und/oder verpresst. Die Zwischenlage 3a kann auch als Laminat-Kern bezeichnet werden und besteht beispielsweise aus FR4. Die Zwischenlage 3a ist folglich ein Dielektrikum, wobei je nach angestrebter Datenrate ein passendes Dielektrikum mit entsprechenden dielektrischen Verlusten verwendet wird. Die Dicke (Erstreckung in Längsrichtung 6) der Zwischenlage 3a entspricht im Wesentlichen dem Durchmesser des Innenleiters 4a des zumindest einen Kabels 2a bis 2d. Der Wortlaut "ungefähr" ist dahingehend zu verstehen, dass der Durchmesser des Innenleiters 4a um vorzugsweise weniger als 40%, 30%, 20%, 10% kleiner ist als die Dicke der Zwischenlage 3a. Die Dicke der Zwischenlage 3a beträgt vorzugsweise weniger als 3mm, 2mm, 1mm, 0,7mm, 0,6mm, 0,5mm. Je nach Durchmesser des Innenleiters 4a kann die Dicke der Zwischenlage 3a entsprechend gewählt werden.

Die erste Außenlage 3b besteht vorzugsweise aus Kupfer mit einer Dicke von 18µm bis 35µm. Selbiges gilt auch für die zweite Außenlage 3c. In diesem Ausführungsbeispiel sind sowohl die erste als auch die zweite Außenlage 3b, 3c elektrisch leitfähig. Dies müsste nicht zwingend der Fall sein. Es wäre ausreichend, wenn eine Außenlage 3b, 3c elektrisch leitfähig wäre. Wie später noch erläutert wird, sind zwar beide Außenlagen 3b, 3c elektrisch leitfähig, allerdings sind diese in unterschiedliche Anschlussbereiche gegliedert, die wiederum nicht galvanisch miteinander verbunden sind. Unter dem Wortlaut "Lage" wird in diesem Zusammenhang lediglich eine Schicht verstanden, wobei diese Schicht entlang der Plattenanordnung 3 nicht zusammenhängend und insbesondere nicht auf dem gleichen elektrischen Potential liegen muss.

In diesem Ausführungsbeispiel umfasst die Plattenanordnung 3 noch eine erste und zweite Decklage 3d, 3e. Bei dieser ersten und zweiten Decklage handelt es sich vorzugsweise um eine (flexible) Lötstoppschicht. Diese verhindert, dass sich beim Auflöten verschiedener elektrischer Bauteile (z.B. Schaltungsträger) das Lötzinn außerhalb von bestimmten Anschlusspads 3g verteilt. Das flüssige Lötzinn, mit dem die elektrischen Bauteile mit entsprechenden Anschlusspads 3g verlötet werden, kommt nicht auf der ersten bzw. zweiten Decklage 3d, 3e zum Liegen. Die Anschlusspads 3g können sich auf der ersten und zweiten Decklage 3d, 3e befinden.

In dem gezeigten Ausführungsbeispiel der Figuren 3A und 3E gibt es noch eine weitere Innenlage 3f. Diese weitere Innenlage 3f ist zwischen der Zwischenlage 3a und der zweiten Außenlage 3c angeordnet. Die zweite Außenlage 3c ist daher lediglich mittelbar und nicht direkt bzw. unmittelbar mit der Zwischenlage 3a verbunden. Bei der weiteren Innenlage 3f handelt es sich beispielsweise um Schicht Polyimid. Diese Schicht hat vorzugsweise eine Schichtdicke von 20µm bis 50µm.

Die eingezeichneten Schichtdicken sind lediglich beispielhaft gewählt. In der Realität wird die Zwischenlage 3a die größte Dicke haben. Die Dicke der Zwischenlage 3a ist vorzugsweise größer als die erste und/oder zweite Außenlage 3b, 3c alleine oder größer als beide Außenlagen 3b, 3c zusammen. Vorzugsweise ist die Schichtdicke der Zwischenlage 3a größer als die Schichtdicken sämtlicher anderer Lagen 3b bis 3f zusammen.

Die Plattenanordnung 3 umfasst zwischen der ersten Außenlage 3b und der zweiten Außenlage 3c noch eine Ausnehmung 7, welche in Figur 3A gestrichelt dargestellt ist. Diese Ausnehmung 7 definiert einen Kabelaufnahmeraum 8, der an einem ersten Seitenrand 3₁ der Plattenanordnung 3 gebildet ist. Wie später noch erläutert wird, werden in diesen Kabelaufnahmeraum 8 Teile der Kabel 2a bis 2d, insbesondere deren freigelegte Innenleiter 4a und ergänzend deren Außenleiter 4d eingeführt. Dieser Kabelaufnahmeraum 8 ist daher von außerhalb der Plattenanordnung 3 zugänglich, wenn keine Anschlussverbindung 1 zwischen der Kabelanordnung 2 und der Plattenanordnung 3 durch Einführen der einzelnen Kabel 2a bis 2d in den Kabelaufnahmeraum 8 hergestellt ist.

Die Ausnehmung 7 ist vorzugsweise durch ein zerspanendes Verfahren, insbesondere einem Fräs- und/oder Bohrprozess zumindest in der Zwischenlage 3a gebildet. Es wäre auch möglich, dass die Ausnehmung 7 dadurch gebildet ist, dass lediglich beim Zusammenstellen der einzelnen Lagen 3a bis 3f weniger Material für die Zwischenlage 3a bzw. die weitere Innenlage 3f verwendet wird, wodurch die erste und die zweite Außenlage 3b, 3c über die Zwischenlage 3a an dem ersten Seitenrand 3₁ überstehen. In diesem Fall würde kein Fräs- und/oder Bohrprozess benötigt werden. Teile der Zwischenlage 3a bzw. der Innenlage 3f könnten vor dem Verkleben und/oder Verpressen der Plattenanordnung 3 auch ausgestanzt bzw. weggeschnitten werden.

Die Ausnehmung 7 der Plattenanordnung 3 ist dabei durch die Kabelanordnung 2 lediglich von der Seite der Plattenanordnung 3 aus zugänglich und nicht von oben bzw. unten. Dies bedeutet, dass die Ausnehmung 7 lediglich mit einem Bewegungsvektor zugänglich ist, der parallel oder mit einer Komponente überwiegend parallel zu den einzelnen Lagen 3a bis 3f verläuft.

Figur 3E zeigt im Unterschied zu Figur 3A noch zumindest eine erste Innenleiterkontaktieröffnung 9a, die die erste Außenlage 3a und die zweite Außenlage 3b durchsetzt und in den Kabelaufnahmeraum 8 mündet. Die zumindest eine erste Innenleiterkontaktieröffnung 9a durchsetzt vorzugsweise beide Außenlagen 3b, 3c. In diesem Fall handelt es sich bei der Innenleiterkontaktieröffnung 9a vorzugsweise um eine Durchkontaktierung (VIA; Vertical Interconnect Access). Die Innenleiterkontaktieröffnung 9a verläuft daher vorzugsweise senkrecht zu den einzelnen Lagen 3a bis 3f, also parallel zur Längsrichtung 6. Eine Innenwandung 10 der ersten Innenleiterkontaktieröffnung 9a ist vorzugsweise mit einer Metallschicht galvanisiert.

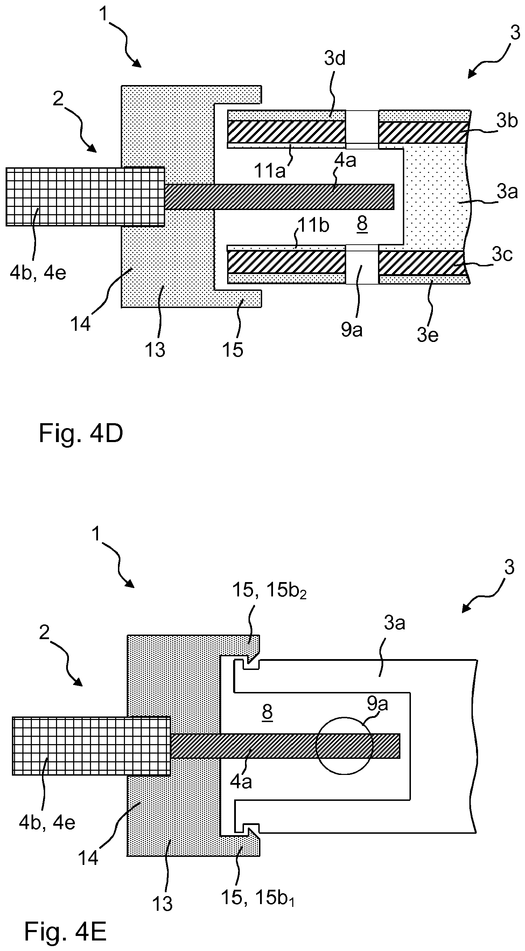

In den meisten Zeichnungsfiguren durchsetzt diese erste Innenleiterkontaktieröffnung 9a lediglich die beiden Außenlagen 3b, 3c und die beiden Decklagen 3d, 3e. Im Hinblick auf die Figuren 4D und 8C ist dagegen gezeigt, dass auch die Zwischenlage 3a die Ausnehmung 7 entlang der Längsrichtung 6 begrenzt und nicht vollständig entfernt wurde. Dies bedeutet, dass sich die Ausnehmung 7 nur über einen Teil der gesamten Dicke der Zwischenlage 3a erstreckt, wodurch die Zwischenlage 3a zwei voneinander beabstandete Bereiche 11a, 11b umfasst, die parallel zu den Außenlagen 3b, 3c verlaufen. Der erste Bereich 11a ist dabei an der ersten Außenlage 3b und der zweite Bereich 11b an der zweiten Außenlage 3c angeordnet. Diese beiden Bereiche 11a, 11b der Zwischenlage 3a begrenzen dabei den Kabelaufnahmeraum 8 in Längsrichtung 6. Die zumindest eine erste Innenleiterkontaktieröffnung 9a durchsetzt auch diese Bereiche 11a, 11b der Zwischenlage 3a. Vorzugsweise ist auch deren Innenwandung 10 galvanisiert, also elektrisch leitfähig.

Der Durchmesser der zumindest einen ersten Innenleiterkontaktieröffnung 9a ist vorzugsweise kleiner als der Durchmesser des Innenleiters 4a eines Kabels 2a bis 2d. Die erste Innenleiterkontaktieröffnung 9a ist vorzugsweise näher am hinteren Ende des Aufnahmeraums 7 angeordnet als am vorderen Ende des Aufnahmeraums 7, wobei das vordere Ende des Aufnahmeraums 7 am ersten Seitenrand 3₁ liegt bzw. beginnt. Die zumindest eine erste Innenleiterkontaktieröffnung 9a könnte allerdings auch in der Mitte oder in der ersten Hälfte (näher am ersten Seitenrand 3₁) bezogen auf die Länge des Aufnahmeraums 7 angeordnet sein.

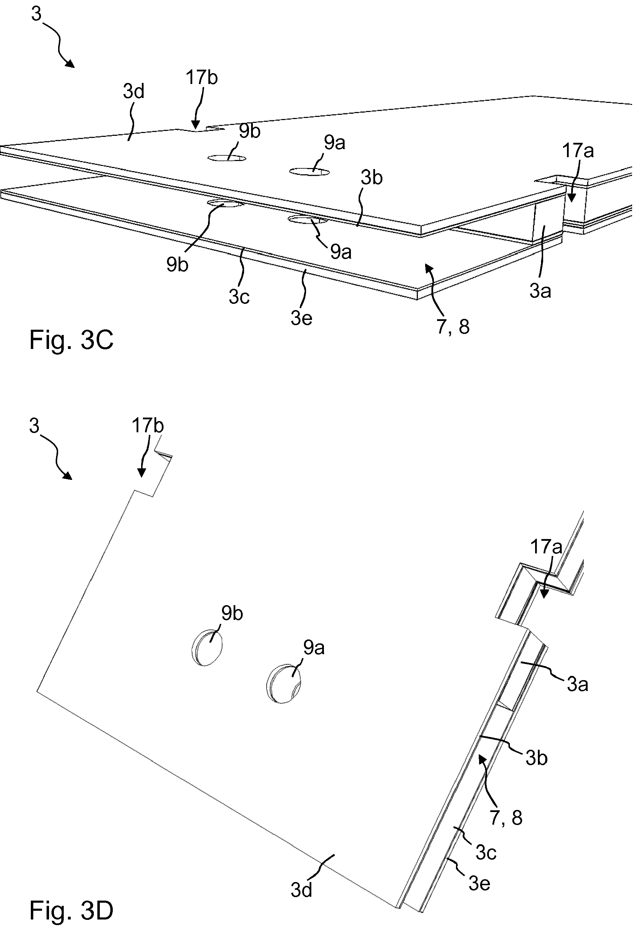

Die Figuren 3B bis 3D zeigen verschiedene beispielhafte räumliche Ausgestaltungen der Plattenanordnung 3. Neben einer ersten Innenleiterkontaktieröffnung 9a, die in der Figur 3B lediglich in der ersten Außenlage 3b eingebracht ist, gibt es noch zumindest eine zweite Innenleiterkontaktieröffnung 9b. Diese entspricht bezüglich ihres Aufbaus demjenigen Aufbau der zumindest einen ersten Innenleiterkontaktieröffnung 9a. In Figur 3B sind lediglich drei Lagen 3a, 3b, 3c dargestellt, wohingegen die Figuren 3C und 3D einen räumlichen Aufbau zeigen, dessen geschnittene Darstellung der Figur 3E zu entnehmen ist (Ausnahme: Anschlusspads 3g).

In Figur 3B wurde die Ausnehmung 7 eingefräst bzw. eingebohrt. Grundsätzlich hätte die Ausnehmung 7 auch vor der Herstellung der Plattenanordnung 3 durch einen Stanzprozess aus der Zwischenlage 3a ausgestanzt bzw. ausgeschnitten werden können. In Figur 3B ist die Ausnehmung 7 lediglich über den ersten Seitenrand 3₁ von außen zugänglich. Ein zweiter Seitenrand 3₂ und ein dritter Seitenrand 3₃ der Plattenanordnung 3 laufen vor bis zum ersten Seitenrand 3₁ und bilden mit diesem jeweils einen Winkel von vorzugsweise 90° (Abweichungen von weniger als 40°, 30°, 20°, 15°, 10°, 5° sind umfasst). Der zweite und der dritte Seitenrand 3₂, 3₃ sind in Figur 3B von außen unzugänglich, also geschlossen.

Anders sieht dies bei den Figuren 3C und 3D aus. Hier ist der Aufnahmeraum 7 von dem zweiten und dritten Seitenrand 3₂, 3₃ ebenfalls zugänglich. Wie bereits erläutert zählen die Innenleiterkontaktieröffnungen 9a, 9b nicht als Zugang zum Aufnahmeraum 7. Die Plattenanordnung 3 gemäß den Figuren 3C und 3D kann durch ein zerspanendes Verfahren hergestellt werden, wobei das verwendete Zerspanungswerkzeug mit einer entsprechenden Vorstelltiefe, die der Tiefe (Länge) des Aufnahmeraums entspricht, vom zweiten Seitenrand 3₂ in Richtung des dritten Seitenrands 3₃ auf Höhe der Zwischenlage 3a verfahren wird. Dieses Verfahren kann noch in mehreren stufenförmigen Absätzen, also in mehreren verschiedenen Tiefen erfolgen.

Grundsätzlich könnte die Plattenanordnung 3 gemäß den Figuren 3C und 3D auch in einem Stanzprozess hergestellt werden, wobei vor Herstellung der Plattenanordnung 3 ein Teil der Zwischenlage 3a ausgestanzt bzw. ausgeschnitten und entfernt wird. Grundsätzlich könnte auch einfach weniger Material für die Zwischenlage 3a verwendet werden als für die weiteren Lagen 3b, 3c bzw. 3d, 3e.

Die Plattenanordnung 3 weist eine Dicke auf, die vorzugsweise kleiner ist als 15mm, 13mm, 1mm, 9mm, 8mm, 7mm, 6mm, 5mm, 4mm, 3mm, 2mm und die weiterhin vorzugsweise größer ist als 1mm, 2mm, 3mm, 4mm, 5mm, 6mm, 7mm, 8mm, 9mm, 10mm. Die Tiefe (Länge) des Kabelaufnahmeraums 8, also beginnend ab dem ersten Seitenrand 3₁ zur vollständig aufgebauten Zwischenlage 3a beträgt vorzugsweise weniger als 20mm, 18mm, 16mm, 14mm, 12mm, 10mm, 8mm, 6mm und ist vorzugsweise größer als 5mm, 7mm, 9mm, 11mm, 13mm, 15mm, 17mm, 19mm. Die Breite der Ausnehmung, also von dem beispielsweise offenen zweiten Ende 3₂ hin zu dem offenen dritten Ende 3₃, beträgt vorzugsweise weniger als 50mm, 40mm, 30mm, 26mm, 22mm, 18mm, 14mm, 10mm, 6mm und ist vorzugsweise größer als 8mm, 12mm, 16mm, 20mm, 24mm, 28mm, 35mm, 45mm.

Die Figuren 4A bis 4E zeigen verschiedene Möglichkeiten wie die erfindungsgemäße Anschlussverbindung 1 hergestellt wird. Die Figuren 4A bis 4D zeigen dabei jeweils eine zumindest teilweise geschnittene (Längsschnitt) Darstellung durch die erfindungsgemäße Anschlussverbindung 1 mit der Kabelanordnung 2 und der Plattenanordnung 3. Figur 4E zeigt dagegen eine Draufsicht auf die erfindungsgemäße Anschlussverbindung 1, wobei die erste und zweite Außenlage 3b, 3c der Plattenanordnung 3 nicht dargestellt ist.

Die Kabelanordnung 2 umfasst in den Figuren 4A bis 4E lediglich ein erstes Kabel 2a mit dem Innenleiter 4a und dem Dielektrikum 4b bzw. dem Außenmantel 4e. Das zumindest eine erste Kabel 2a umfasst keinen Außenleiter 4d. Gezeigt ist ebenfalls, dass die zumindest eine erste Innenleiterkontaktieröffnung 9a mit zumindest einem ersten Innenleiterlotdepot 12a versehen ist.

Der Abstand zwischen dem Innenleiter 4a und der zumindest einen ersten Innenleiterkontaktieröffnung 9a ist in den Zeichnungsfiguren nicht maßstabsgetreu dargestellt. Der Innenleiter 4a ist in der Realität nur minimal (vorzugsweise weniger als 3mm, 2mm, 1mm) von der ersten und/oder zweiten Außenlage 3b, 3c beabstandet.

Der Innenleiter 4a ist allerdings mit seiner Stirnseite beabstandet, also kontaktfrei zu einer Stirnseite der Zwischenlage 3a angeordnet.

Das zumindest eine erste Kabel 2a der Kabelanordnung 2 ist über die zum ersten Seitenrand 3₁ hin geöffnete Ausnehmung 7 in diese und damit in den Kabelaufnahmeraum 8 eingeführt. Das zumindest eine erste Kabel 2a wird dabei mit einem Bewegungsvektor in den Kabelaufnahmeraum 8 eingeführt, der parallel oder überwiegend parallel zur ersten und/oder zweiten Außenlage 3b, 3c bzw. zur Zwischenlage 3a verläuft. Das zumindest eine erste Kabel 2a endet mit seinem Innenleiter 4a in dem Kabelaufnahmeraum 8 und steht mit dem Ende des freigelegten Innenleiters 4a nicht aus dem Kabelaufnahmeraum 8 heraus.

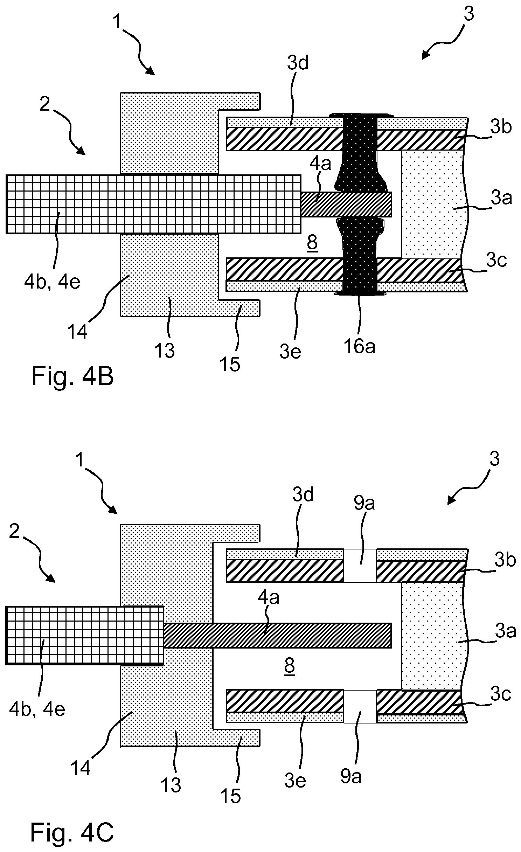

In Figur 4A ist gezeigt, dass die Kabelanordnung 2 noch eine Kabelsammel- und Ausrichteinrichtung 13 umfasst, die einen Grundkörper 14 aufweist. Die Kabelsammel- und Ausrichteinrichtung 13 ist vorzugsweise unverschiebbar an dem zumindest einen ersten Kabel 2a oder an allen Kabeln 2a bis 2d angeordnet. Insbesondere ist die Kabelsammel- und Ausrichteinrichtung 13 an dem Dielektrikum 4b bzw. Außenmantel 4e angeordnet. Im Hinblick auf Figur 4C ist gezeigt, dass die Kabelsammel- und Ausrichteinrichtung 13 auch noch den Innenleiter 4a umschließen kann.

Die Kabelsammel- und Ausrichteinrichtung 13 besteht aus einem dielektrischen Material, beispielsweise aus einem Kunststoff. Sie kann ein Kunststoffgehäuse umfassen, in welches das zumindest eine erste Kabel 2a eingelegt wird, worauf das Kunststoffgehäuse fest verschlossen wird. Vorzugsweise wird allerdings das zumindest eine erste Kabel 2a mit einem Kunststoff umspritzt, wodurch die Kabelsammel- und Ausrichteinrichtung 13 gebildet ist. Wie später noch erläutert wird, umfasst die Kabelsammel- und Ausrichteinrichtung 13 noch eine Befestigungseinrichtung 15, die dazu ausgebildet ist, die Kabelsammel- und Ausrichteinrichtung 13 derart an der Plattenanordnung 3 zu befestigen, dass das zumindest eine erste Kabel 2a oder alle Kabel 2a bis 2d der Kabelanordnung 2 lageunveränderlich zueinander angeordnet in den Kabelaufnahmeraum 8 einführbar und in dem Kabelaufnahmeraum 8 lageunveränderlich zueinander angeordnet sind. Die Befestigungseinrichtung 15 ist dabei insgesamt gewinde- bzw. schraubenfrei und lötfrei ausgestaltet.

Das zumindest eine erste Kabel 2a bzw. alle Kabel 2a bis 2d sind dabei durch den Grundkörper 14 der Kabelsammel- und Ausrichteinrichtung 13 hindurch geführt. Der Grundkörper 14 umfasst beispielsweise einen rechteckförmigen Längsschnitt bzw. ist quaderförmig ausgebildet. In Figur 4B ist die Anschlussverbindung 1 vollständig hergestellt. Das in Figur 4A gezeigte erste Innenleiterlotdepot 12a wurde erhitzt bis es schmelzflüssig wurde und eine erste Innenleiterlötverbindung 16a hergestellt hat, über die der Innenleiter 4a das zumindest einen ersten Kabels 2a zumindest im Bereich der ersten Innenleiterkontaktieröffnung 9a mit einem ersten Innenleiteranschlussbereich 9a₁ der ersten und/oder zweiten Außenlage 3b, 3c elektrisch leitfähig verlötet ist. Wie bereits erläutert, wird unter dem Begriff Außenlage 3b, 3c die gesamte elektrisch leitfähig Metallschicht verstanden, wobei diese Metallschicht in unterschiedliche, voneinander galvanisch getrennte Anschlussbereiche (z.B. erster Innenleiteranschlussbereich 9a₁) gegliedert ist.

Das erste Innenleiterlotdepot 12a kann mittels einer aufgeheizten Spitze eines Lötkolbens bzw. einer Lötvorrichtung schmelzflüssig gemacht werden. Bevorzugt wird allerdings ein induktives (berührungsloses) Lötverfahren eingesetzt.

Grundsätzlich könnte das zumindest eine erste Innenleiterlotdepot 12a auch in Form eines Lotrings bzw. einer Lothülse am Innenleiter 4a des zumindest einen ersten Kabels 2a angeordnet sein.

Figur 4D zeigt außerdem, dass die Ausnehmung 7 lediglich in die Zwischenlage 3a eingebracht ist, allerdings nicht über die gesamte Dicke der Zwischenlage 3a verläuft. Wie bereits erläutert, wird dadurch die Zwischenlage 3a in voneinander beabstandete Bereiche 11a, 11b unterteilt, die in Richtung des ersten Seitenrands 3₁ verlaufen. Die erste Innenleiterkontaktieröffnung 9a durchsetzt dabei beide Bereiche 11a, 11b der Zwischenlage 3a. Eine elektrische Kontaktierung des Innenleiters 4a mit dem ersten Innenleiteranschlussbereich 9a₁ der ersten und/oder zweiten Außenlage 3b, 3c erfolgt über die Innenwandung 10 der Innenleiterkontaktieröffnung 9a. Diese Innenwandung 10 ist insbesondere mit einer Metallschicht galvanisiert.

Durch diese vorgezogenen Bereiche 11a, 11b der Zwischenlage 3a wird sichergestellt, dass es keine unerwünschte elektrische Kontaktierung zwischen dem Innenleiter 4a und den verschiedenen Bereichen der ersten und/oder zweiten Außenlage 3b, 3c gibt.

In Figur 4E ist eine Draufsicht auf die Anschlussverbindung 1 dargestellt. Die erste und/oder zweite Außenlage 3b, 3c ist nicht dargestellt. Angedeutet ist die erste Innenleiterkontaktieröffnung 9a, die bezüglich ihres Durchmessers vergrößert dargestellt ist. Der Durchmesser der ersten Innenleiterkontaktieröffnung 9a ist vorzugsweise kleiner als der Durchmesser des Innenleiters 4a. Der Innenleiter 4a des zumindest einen ersten Kabels 2a ist, wie in Figur 4E dargestellt, an dem ersten Seitenrand 3₁ in den Kabelaufnahmeraum 8 eingeführt und in Draufsicht auf die erste und/oder zweite Außenlage 3b, 3c unter der zumindest einen ersten Innenleiterkontaktieröffnung 9a angeordnet. Der Wortlaut "unter" ist dahingehend zu verstehen, dass bei einer Draufsicht auf die erste oder zweite Außenlage 3b, 3c der Innenleiter 4a bei einem Blick durch die erste Innenleiterkontaktieröffnung 9a zu sehen ist. Der Innenleiter 4a muss allerding nicht mittig unter der ersten Innenleiterkontaktieröffnung 9a verlaufen. Er könnte auch außermittig (versetzt) unter dieser hindurchlaufen. Der Wortlaut "unter" gilt dabei sowohl mit Blick auf die erste als auch auf die zweite Außenlage 3b, 3c, die jeweils "oberhalb" des Innenleiters 4a angeordnet ist. Insbesondere besteht daher in Draufsicht auf die erste oder zweite Außenlage 3b, 3c Sichtkontakt über die erste Innenleiterkontaktieröffnung 9a auf den Innenleiter 4a.

Weiterhin ist noch die Befestigungseinrichtung 15 dargestellt, die ein Ablösen bzw. ein Abziehen der Kabelanordnung 2 von der Plattenanordnung 3 verhindert bzw. für eine Zugentlastung des zumindest einen ersten Kabels 2a sorgt, so dass die erste Innenleiterlötverbindung 16a nicht beeinträchtigt wird. Die hier dargestellte Art der Befestigungseinrichtung 15 wird im Hinblick auf die späteren Ausführungsbeispiele noch genauer beschrieben.

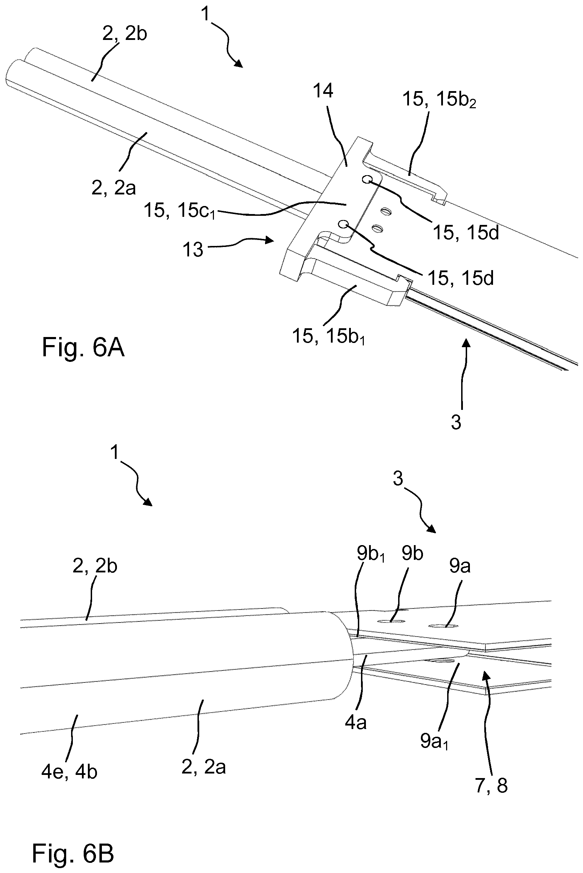

Figur 4F zeigt, dass die Kabelanordnung 2 noch zumindest ein zweites Kabel 2b umfasst. Dargestellt ist, dass das zweite Kabel 2b einen Innenleiter 4a und ein Dielektrikum 4b bzw. einen Außenmantel 4e umfasst. Ein Außenleiter 4d ist hier nicht vorgesehen. Die Kabel 2a, 2b der Kabelanordnung 2 sind nebeneinander angeordnet. Sie liegen vorzugsweise zumindest bezüglich ihrer frei gelegten Innenleiter 4a in einer gemeinsamen Ebene, wobei diese gemeinsame Ebene wiederum parallel zur Plattenanordnung 3 bzw. parallel zu den einzelnen Lagen 3a bis 3f verläuft. Die Innenleiter 4a der beiden Kabel 2a, 2b sind galvanisch voneinander getrennt und berührungsfrei zueinander angeordnet. Weiterhin ist eine zweite Innenleiterkontaktieröffnung 9b vorgesehen, die wie die erste Innenleiterkontaktieröffnung 9a aufgebaut ist. Die zweite Innenleiterkontaktieröffnung durchsetzt ebenfalls die erste und/oder die zweite Außenlage 3b, 3c und mündet in den Kabelaufnahmeraum 8. Der Innenleiter 4a des zumindest einen zweiten Kabels 2b ist an dem ersten Seitenrand 3₁ in den Kabelaufnahmeraum 8 eingeführt und in Draufsicht auf die erste oder zweite Außenlage 3b, 3c unter der zumindest einen zweiten Innenleiterkontaktieröffnung 9b angeordnet. Auch der Innenleiter 4a des zumindest einen zweiten Kabels 2b ist über eine zweite Innenleiterlötverbindung (nicht dargestellt) zumindest im Bereich der zweiten Innenleiterkontaktieröffnung 9b mit einem zweiten Innenleiteranschlussbereich 9b₁ (s. Figur 6B) der ersten und/oder zweiten Außenlage 3b, 3c elektrisch leitfähig verlötet. Der erste Innenleiteranschlussbereich 9a₁ und der zweite Innenleiteranschlussbereich 9b₁ sind dabei galvanisch voneinander getrennt.

Die Befestigungseinrichtung 15 der Kabelsammel- und Ausrichteinrichtung 13 umfasst noch mehrere Trennstege 15a, die von dem zumindest einen Grundkörper 14 aus in Richtung der Plattenanordnung 3 verlaufen und in dem Kabelaufnahmeraum 8 enden. Die Trennstege 15a bestehen ebenfalls aus einem dielektrischen Material. Insbesondere ist die Kabelsammel- und Ausrichteinrichtung 13 zusammen mit ihrer Befestigungseinrichtung 15 und dem Grundkörper 14 einteilig ausgebildet und insbesondere in einem Kunststoffspritzgussverfahren hergestellt.

Die Trennstege 15a verlaufen dabei in dieselbe Richtung wie die Innenleiter 4a der beiden Kabel 2a, 2b. Die Trennstege 15a stehen vorzugsweise über die Stirnseiten, also die Enden der Innenleiter 4a hervor. Dies bedeutet, dass beim Einschieben der Kabelanordnung 2, also der Innenleiter 4a und der Trennstege 15a, in den Kabelaufnahmeraum 8 die Trennstege 15a mit ihren Stirnseiten zuerst in eine Anschlagsposition mit der Zwischenlage 3a gelangen können.

Die Trennstege 15a flankieren daher die Innenleiter 4a der Kabel 2a, 2b. Jeder Innenleiter 4a ist vorzugsweise von zumindest zwei Trennstegen 15a umgeben.

Grundsätzlich wäre es auch möglich, ein Kabel 2a, 2b auch nur von einem Trennsteg 15a flankiert wird.

In Figur 4F enden die Trennstege 15a und die Innenleiter 4a der beiden Kabel 2a, 2b auf gleicher Höhe.

Die Trennstege 15a weisen eine Dicke auf, die kleiner ist als die Dicke der Ausnehmung 7.

Figur 5 zeigt eine räumliche Darstellung der Kabelsammel- und Ausrichteinrichtung 13 der Kabelanordnung 2. Die Trennstege 15a der Befestigungseinrichtung 15 wurden bereits erläutert. Die einzelnen Trennstege 15a können dabei unterschiedlich breit sein, wobei ihre Dicke vorzugsweise gleich ist. In dem Ausführungsbeispiel aus Figur 5 sind die äußeren beiden Trennstege 15a breiter als der mittlere Trennsteg 15a. Die Trennstege 15a sind von allen Seiten in Richtung ihres freistehenden Endes abgeflacht, um ein Einführen in den Aufnahmeraum 7 zu erleichtern.

Die Befestigungseinrichtung 15 umfasst außerdem noch einen ersten Rasthaken 15b₁ und einen zweiten Rasthaken 15b₂. Die Rasthaken 15b₁, 15b₂ entspringen an verschiedenen Bereichen des Grundkörpers 14, insbesondere an verschiedenen Enden des Grundkörpers 14 (aber vorzugsweise an derselben Seite des Grundkörpers 14) und verlaufen in Richtung des zweiten und dritten Seitenrands 3₂ und 3₃ der Plattenanordnung 3. Im Hinblick auf die Figur 3D ist eine erste Rastöffnung 17a und eine zweite Rastöffnung 17b zu erkennen. Die erste Rastöffnung 17a ist an dem zweiten Seitenrand 3₂ ausgebildet und die zweite Rastöffnung 17b an dem dritten Seitenrand 3₃. Die Rastöffnungen 17a, 17b durchsetzen vorzugsweise sämtliche Lagen 3a bis 3f der Plattenanordnung 3. Die Rastöffnungen 17a, 17b können beispielsweise nach Herstellung der Plattenanordnung 3 in einem Stanzprozess in diese eingebracht werden. Sie könnten allerdings schon in den einzelnen Lagen 3a bis 3f eingebracht sein, also noch bevor die einzelnen Lagen 3a bis 3f mit der Plattenanordnung 3 verklebt und/oder verpresst werden. Die Rastöffnungen 17a, 17b sind daher nicht nur von dem zweiten und dritten Seitenrand 3₂, 3₃ aus zugänglich, sondern auch in Draufsicht auf die erste und zweite Außenlage 3b, 3c. Die Rastöffnungen 17a, 17b haben vorzugsweise ein würfelförmiges Volumen.

Der erste Rasthaken 15b₁ greift dabei in die erste Rastöffnung 17a und der zweite Rasthaken 15b₂ in die zweite Rastöffnung 17b ein. Insbesondere hintergreifen die Rasthaken 15b₁, 15b₂ eine durch die Eingriffsöffnung 17a, 17b in der Plattenanordnung 3 gebildete Auflageschulter. Durch dieses Hintergreifen ist ein Abziehen vor der Verlötung nur dann möglich, wenn die Rasthaken 15b₁, 15b₂ nach außen, also voneinander weg gedrückt werden. Grundsätzlich sind die Rasthaken 15b₁, 15b₂ federnd ausgebildet. Sie sollten sich dabei zumindest aufeinander zu und voneinander weg bewegen können. Der vordere Teil der Rasthaken 15b₁, 15b₂, also das offene Ende, ist vorzugsweise L-förmig und weiter vorzugsweise zumindest teilweise schräg bzw. konisch in Richtung des Grundkörpers 14 vergrößert, so dass beim Herstellen der Anschlussverbindung 1, also beim Einschieben der Kabelanordnung 2 in die Plattenanordnung 3 die Rasthaken 15b₁, 15b₂ so lange voneinander weg gedrückt werden, bis der vordere Hakenabschnitt der einzelnen Rasthaken 15b₁, 15b₂ in die entsprechende Rastöffnung 17a, 17b eingreift. Die Rasthaken 15b₁, 15b₂ weisen eine Dicke auf, die in etwa derjenigen der Plattenanordnung 3 entspricht. Die Dicke kann allerdings auch kleiner oder größer sein. Bevorzugt sind die Rasthaken 15b₁, 15b₂ entlang der Längsrichtung 6 weniger federnd ausgebildet als entlang der Bewegungsrichtung, bei der die Rasthaken aufeinander zu oder voneinander weg bewegt werden.

Die Befestigungseinrichtung 15 umfasst außerdem noch eine erste und eine zweite Befestigungszunge 15c₁, 15c₂. Die beiden Befestigungszungen 15c₁, 15c₂ erstrecken sich vom Grundkörper 14 aus in Richtung der Plattenanordnung 3 weg. Die Plattenanordnung 3 ist mit ihrer ersten Seitenwand 3₁ zwischen den zwei Befestigungszungen 15c₁, 15c₂ angeordnet. Dies bedeutet, dass die erste Befestigungszunge 15c₁ auf der ersten Außenlage 3b und die zweite Befestigungszunge 15c₂ auf der zweiten Außenlage 3c aufliegt. Die Befestigungszungen 15c₁, 15c₂ erstrecken sich vorzugsweise weniger weit in Richtung der Plattenanordnung 3 als die Rasthaken 15b₁, 15b₂. Die Befestigungszungen 15c₁, 15c₂ erstrecken sich außerdem weniger weit in Richtung der Plattenanordnung 3 als die Trennstege 15a. Die Befestigungszungen 15c₁, 15c₂ überdecken insbesondere nicht die erste bzw. zweite oder die weiteren Innenleiterkontaktieröffnungen 9a, 9b, 9c, 9d. Die Befestigungszungen 15c₁, 15c₂ überdecken insbesondere auch nicht die erste bzw. zweite oder die weiteren Außenleiterkontaktieröffnungen 18a, 18b, 18c, 18d, die später noch erläutert werden.

Die Befestigungszungen 15c₁, 15c₂ erstrecken sich über den überwiegenden Teil (mehr als 50%) der Länge des Grundkörpers 14.

Die Trennstege 15a, die Rasthaken 15b₁, 15b₂ und die Befestigungszungen 15c₁, 15c₂ verlaufen alle in dieselbe Richtung.

Die Befestigungseinrichtung 15 umfasst noch zumindest zwei Befestigungsstifte 15d (Figur 6A), die durch die beiden Befestigungszungen 15c₁, 15c₂ und die Plattenanordnung 3 und in dieser insbesondere durch die erste und zweite Außenlage 3b, 3c verlaufen, wodurch ein Abziehen der Kabelanordnung 2 von der Plattenanordnung 3 verhindert wird. Die Befestigungsstifte 15d werden vorzugsweise eingepresst. Eine Verklebung der Befestigungszungen 15c₁, 15c₂ mit den Außenlagen 3b, 3c anstelle der Befestigungsstifte 15d könnte auch möglich sein.

Die Befestigungszungen 15c₁, 15c₂ sind das bevorzugte Befestigungsmittel der Befestigungseinrichtung 15, weil der Einsatz der Rasthaken 15b₁, 15b₂ es erfordert, dass die Plattenordnung 3 eine genau bestimmte Breite aufweist. Bei Einsatz der Befestigungszungen 15c₁, 15c₂, die mit den Befestigungsstiften 15d arretiert werden, kann die Plattenanordnung eine beliebige Breite aufweisen.

Anstelle der Befestigungsstifte kann auch eine Kugelrastung unterhalb der jeweiligen Befestigungszunge 15c₁, 15c₂ verwendet werden. In diesem Fall würde ein Vorsprung, insbesondere in Form einer Kugel, von beiden Befestigungszungen 15c₁, 15c₂ in Richtung der ersten und zweiten Außenlage 3b, 3c, also in Längsrichtung 6 vorstehen, die in eine entsprechende Aufnahmeöffnung zumindest in der ersten und zweiten Außenlage 3b, 3c eingreifen. Diese Art der Befestigung ist zwar nicht so effektiv wie mit den Befestigungsstiften 15d, allerdings günstiger in der Herstellung.

Die Figuren 6A und 6C zeigen den Einsatz der Kabelsammel- und Ausrichteinrichtung 13. In diesen Figuren ist die Anschlussverbindung 1 hergestellt. So umfasst die Kabelanordnung 2 in der Figur 6A zwei Kabel 2a, 2b, an denen die Kabelsammel- und Ausrichteinrichtung 13 (im montierten Zustand) unverschiebbar angeordnet ist. Insbesondere verlaufen die Kabel 2a, 2b durch den Grundkörper 14 hindurch. Die Befestigungseinrichtung 15 der Kabelsammel- und Ausrichteinrichtung 13 greift dabei an verschiedenen Stellen in die Plattenanordnung 3 ein, so dass eine Zugentlastung ermöglicht wird, wodurch auch bei Ziehen an den Kabeln 2a, 2b keine Beschädigung der Innenleiterlötverbindungen 16a stattfindet.

In Figur 6B ist eine Sicht in den geöffneten Aufnahmeraum 7 dargestellt, wo zu erkennen ist, wie die Innenleiter 4a der Kabel 2a, 2b in dem Kabelaufnahmeraum 8 unter den jeweiligen Innenleiterkontaktieröffnungen 9a, 9b angeordnet sind.

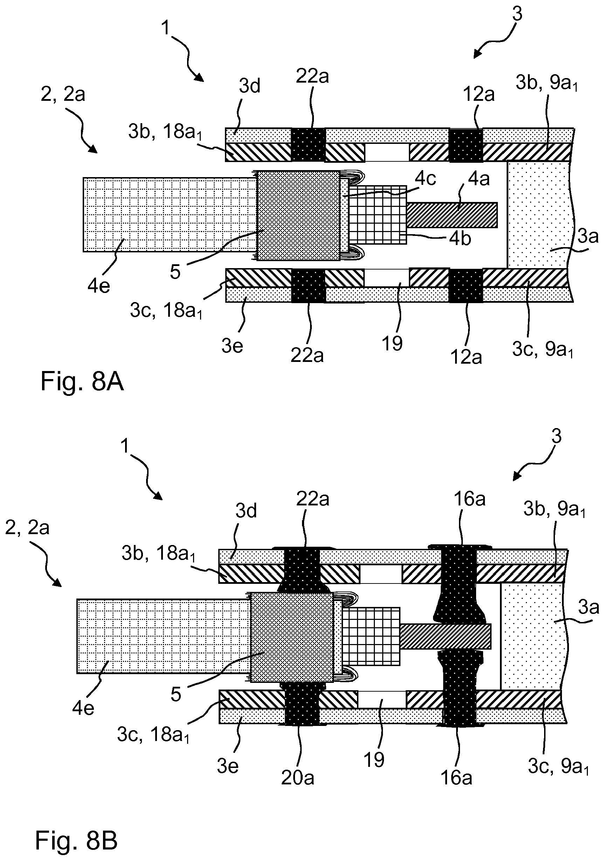

Die Figuren 7 und 8A bis 8D zeigen ein weiteres Ausführungsbeispiel der erfindungsgemäß Anschlussverbindung 1, bei welcher das zumindest eine erste Kabel 2a sowohl mit seinem Innenleiter 4a als auch mit seinem Außenleiter 4d mit der Plattenanordnung 3 verlötet wird.

Figur 7 zeigt dabei eine vereinfachte Schnittdarstellung durch eine entsprechende Plattenanordnung 3. Die Plattenanordnung 3 umfasst außerdem noch eine erste Außenleiterkontaktieröffnung 18a, die die erste Außenlage 3b und/oder die zweite Außenlage 3c durchsetzt und in den Kabelaufnahmeraum 8 mündet. Die erste Außenleiterkontaktieröffnung 18a entspricht bezüglich ihres Aufbaus und ihrer Herstellung vorzugsweise der ersten Innenleiterkontaktieröffnung 9a. Die Außenleiterkontaktieröffnung 18a ist näher an dem ersten Seitenrand 3₁ angeordnet als die erste Innenleiterkontaktieröffnung 9a. Eine Innenwandung 21 der ersten Außenleiterkontaktieröffnung 18a ist vorzugsweise mit einer Metallschicht galvanisiert.

In Figur 7 ist dargestellt, dass die erste Außenlage 3b und die zweite Außenlage 3c unterschiedliche Schraffierungen aufweisen. Diese unterschiedlichen Schraffierungen sollen verdeutlichen, dass die erste Außenlage 3b und die zweite Außenlage 3c unterschiedliche Anschlussbereiche 9a₁, 18a₁ umfassen. So gibt es einen Innenleiteranschlussbereich 9a₁ und einen Außenleiteranschlussbereich 18a₁. Beide Anschlussbereiche 9a₁, 18a₁ sind durch eine Unterbrechung 19 galvanisch voneinander getrennt. Sie sind allerdings vorzugsweise aus demselben Metallsubstrat gebildet. Dies bedeutet, dass der erste Innenleiteranschlussbereich 9a₁ galvanisch von dem ersten Außenleiteranschlussbereich 18a₁ getrennt ist. Diese Unterbrechung 19 kann beim Aufbau der ersten und/oder der zweiten Außenlage 3b, 3c durch einen fehlenden Aufbau der Metallschicht eingebracht werden bzw. die Metallschicht kann in einem späteren Ätz- und/oder Fräsprozess wieder entfernt werden, wodurch die Unterbrechung 19 gebildet ist. Der Innenleiteranschlussbereich 9a₁ wird vorzugsweise durch eine Signalleitung gebildet, wohingegen der Außenleiteranschlussbereich 18a₁ durch eine Massefläche gebildet wird, die breiter als die Signalleitung ist.

In Figur 8A ist ein erstes Kabel 2a dargestellt, welches den Innenleiter 4a, ein den Innenleiter 4a umgebendes Dielektrikum 4b, einen Außenleiter 4d und einen den Außenleiter umgebenden Außenleitermantel 4e umfasst. Der Außenleitermantel 4e und das Dielektrikum 4d sind nicht elektrisch leitfähig. Der Außenleiter 4d umfasst ein Schirmdrahtgeflecht, dessen Schirmdrähte nach hinten, also in eingeführtem Zustand in Richtung des ersten Seitenrands 3₁ zurückgeklappt bzw. umgeklappt sind, wie dies im Hinblick auf die Figuren 2A und 2B beschrieben worden ist. Auf diesen Außenleiter 4d ist noch eine Metallfolie 5 aufgebracht, die dafür sorgt, dass die Schirmdrähte an Ort und Stelle bleiben. Diese elektrisch leitfähige Metallfolie 5 kann auch als Löt-Hilfe bezeichnet werden. Bei dem zumindest einen ersten Kabel 2a handelt es sich in diesem Fall um ein Koaxialkabel. Das Schirmgeflecht, ist vorzugsweise weg von dem in den Kabelaufnahmeraum 8 eingeführten Ende des zumindest einen ersten Kabels 2a nach hinten umgestülpt.

In Figur 8A ist der Außenleiter 4d des zumindest einen ersten Kabels 2a zumindest teilweise bzw. überwiegend bezüglich seiner Länge an dem ersten Seitenrand 3₁ in den Kabelaufnahmeraum 8 eingeführt. In Draufsicht auf die erste oder zweite Außenlage 3b, 3c ist der Außenleiter 4d unter der zumindest einen ersten Außenleiterkontaktieröffnung 18a angeordnet. Der Innenleiter 4a ist dagegen unter der zumindest einen ersten Innenleiterkontaktieröffnung 9a angeordnet.

In Figur 8A ist neben dem zumindest einen ersten Innenleiterlotdepot 12a auch zumindest ein erstes Außenleiterlotdepot 22a gezeigt. Das zumindest eine erste Außenleiterlotdepot 22a ist vorzugsweise in die Außenleiterkontaktieröffnung 18a eingebracht. Es könnte auch am Außenleiter 4d herum angeordnet sein.

In Figur 8B sind diese beiden Lotdepots 12a, 22a aufgeschmolzen, wobei eine erste Innenleiterlötverbindung 16a und eine erste Außenleiterlötverbindung 20a zum dem Innenleiter 4a bzw. zu dem Außenleiter 4d hergestellt ist. Der Außenleiter 4d des zumindest einen ersten Kabels 2a ist daher über die erste Außenleiterlötverbindung 20a zumindest im Bereich der ersten Außenleiterkontaktieröffnung 18a mit dem ersten Außenleiteranschlussbereich 18a₁ der ersten und/oder zweiten Außenlage 3b, 3c elektrisch leitfähig verlötet. Der Wortlaut "im Bereich" ist dahingehend zu verstehen, dass die Verlötung unter anderem geringfügig beabstandet zur ersten Außenleiterkontaktieröffnung 18a erfolgen kann. Die Außenleiterlötverbindung 20a muss aber dennoch im ersten Außenleiteranschlussbereich 18a₁ erfolgen. Vorzugsweise erfolgt die erste Außenleiterlötverbindung weniger als 10mm, 8mm, 5mm beabstandet von der ersten Außenleiterkontaktieröffnung 18a. Selbiges gilt auch für die Innenleiterlötverbindung 16a, die "im Bereich" der ersten Innenleiterkontaktieröffnung 9a angeordnet ist.

In der Figur 8C ist außerdem noch gezeigt, dass die unterschiedlichen Bereiche 11a, 11b der Zwischenlage 3a entlang der Kabeleinführrichtung eine unterschiedliche Dicke aufweisen. In dem Bereich des Kabelanschlussraums 8, in welchem der Innenleiter 4a des zumindest einen Kabels 2a bei der hergestellten Anschlussverbindung 1 angeordnet ist, sind die beiden Bereiche 11a, 11b dicker als in demjenigen Bereich des Kabelanschlussraums 8, in welchem der Außenleiter 4d des zumindest einen ersten Kabels 2a verlötet werden soll.

Figur 8D zeigt eine Draufsicht auf die erfindungsgemäße Anschlussverbindung 1, die zumindest vier Kabel 2a bis 2d mit entsprechenden Anschlussbereichen 9a₁, 18a₁ bzw. 9b₁ kontaktiert. Jedes Kabel 2a bis 2d ist als Koaxialkabel ausgeführt. Der Außenmantel 4e aller Kabel 2a bis 2d ist durch die Kabelsammel- und Ausrichteinrichtung 13 gehalten. Trennstege 15a sind zwischen den freigelegten Außenleitern 4d und den frei gelegten Innenleitern 4a angeordnet. Für jedes Kabel 2a bis 2d gibt es eine Innenleiterkontaktieröffnung 9a, 9b, 9c, 9d und eine Außenleiterkontaktieröffnung 18a, 18b, 18c, 18d. Alle Kabel 2a bis 2d liegen vorzugsweise im Bereich des Kabelaufnahmeraums 8 in einer Ebene.

Es ist auch hier besonders vorteilhaft, dass die Kabelanordnung 2 vollständig vor Herstellen der Anschlussverbindung 1 gefertigt werden kann. Die einzelnen Schichten der Kabel 2a bis 2d werden bereits im Vorfeld freigelegt bzw. konfektioniert und durch die entsprechende Kabelsammel- und Ausrichteinrichtung 13 drehfest und lageunveränderlich gegenseitig fixiert. Eine derartig vorbereitete Kabelanordnung 2 kann problemlos in den Kabelaufnahmeraum 8 eingeführt werden. Die Trennstege 15a führen dazu, dass die Innenleiter 4a nicht in Kontakt zu den einzelnen Lagen 3a bis 3f des Kabelaufnahmeraums 8 gelangen. Die Innenleiter- bzw. Außenleiterkontaktieröffnungen 9a bis 9d bzw. 18a bis 18d, in welche die entsprechenden Innenleiter- bzw. Außenleiterlotdepots 12a, 22a eingebracht sind, können über eine externe Wärmequelle, die sich insbesondere außerhalb der Plattenanordnung 3 befindet, schmelzflüssig gemacht werden, wodurch die einzelnen Kabel 2a bis 2d mit den jeweiligen Anschlussbereichen 9a₁ bzw. 18a₁ verlötet werden.

Grundsätzlich können beliebig viele Kabel 2a bis 2d nebeneinander angeordnet werden. In Grenzen wäre es auch möglich, dass zwei Kabel 2a, 2b übereinander angeordnet werden, wobei der Innenleiter 4a des einen Kabels 2a mit der ersten Außenlage 3b und der Innenleiter 4a des zweiten Kabels 2b mit der zweiten Außenlage 3c verlötet würde. Dies setzt allerdings eine entsprechend dicke Zwischenschicht 3a voraus.

Die einzelnen Außenleiterkontaktierbereiche 18a₁ sämtlicher Kabel 2a bis 2d können elektrisch leitfähig miteinander verbunden sein. Bei den Innenleiterkontaktierbereichen 9a₁, 9b₁ ist dies nicht der Fall. Grundsätzlich könnte auch ein Kabel 2a bis 2d verwendet werden, welches gemäß Figur 1B aufgebaut ist. In diesem Fall würde ein gemeinsamer Außenleiter 4d verwendet werden, der die Dielektrika 4b mit den jeweiligen Innenleitern 4a unterschiedlicher Kabel 2a bis 2d gemeinsam umgibt. Ein solches Kabel 2a bis 2d müsste auch keinen runden Querschnitt mehr aufweisen, sondern könnte im Querschnitt unterschiedlich lange Seiten umfassen.

Grundsätzlich ist neben der Anschlussverbindung 1 auch die Plattenanordnung 3 Teil der Erfindung. Dies gilt insbesondere dann, wenn die erste Innenleiterkontaktieröffnung 9a zumindest ein erstes Innenleiterlotdepot 12a aufweist.

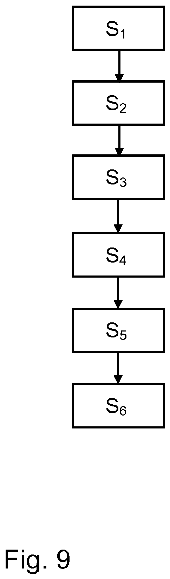

Figur 9 zeigt noch ein Verfahren zur Herstellung der Anschlussverbindung 1 zwischen der Plattenanordnung 3 und der Kabelanordnung 2. In einem ersten Verfahrensschritt S₁ wird die Plattenanordnung 3 hergestellt. Diese umfasst zumindest drei in Längsrichtung 6 aufeinander gestapelte Lagen 3a, 3b, 3c. Dabei ist zumindest die dielektrische Zwischenlage 3a zwischen einer ersten Außenlage 3b und einer zweiten Außenlage 3c angeordnet. Bei der ersten und/oder zweiten Außenlage 3b, 3c handelt es sich insbesondere um Metalllagen (z.B. Kupfer). Eine Ausnehmung 7 wird dabei zwischen der ersten Außenlage 3b und der zweiten Außenlage 3c eingebracht. Dadurch entsteht ein Kabelaufnahmeraum 8, der vom ersten Seitenrand 3₁ der Plattenanordnung 3 aus zugänglich ist.

In einem zweiten Verfahrensschritt S₂ wird zumindest eine erste Innenleiterkontaktieröffnung 9a in die Plattenanordnung 3 eingebracht, wobei diese die erste Außenlage 3b und/oder die zweite Außenlage 3c durchsetzt und in den Kabelaufnahmeraum 8 mündet. Bei der zumindest einen ersten Innenleiterkontaktieröffnung 9a handelt es sich insbesondere um eine Durchkontaktierung, die sich gleichermaßen durch beide Außenlagen 3b, 3c erstreckt. Diese Durchkontaktierung kann beispielsweise in einem Bohrprozess hergestellt werden. Eine Galvanisierung der Innenwandung 10 der ersten Innenleiterkontaktieröffnung 9a ist ebenfalls möglich.

In einem dritten Verfahrensschritt S₃ wird zumindest der Innenleiter 4a des zumindest einen ersten Kabels 2a der Kabelanordnung 2 freigelegt. Dieser Verfahrensschritt kann natürlich auch vor dem ersten bzw. zweiten Verfahrensschritt S₁, S₂ ausgeführt werden.

In einem vierten Verfahrensschritt S₄ wird zumindest ein Innenleiterlotdepot 12a in die Innenleiterkontaktieröffnung 9a und/oder an den freigelegten Innenleiter 4a des zumindest einen ersten Kabels 2a der Kabelanordnung 2 eingebracht bzw. angelegt.

In einem fünften Verfahrensschritt S₅ wird der Innenleiter 4a des zumindest einen ersten Kabels 2a über den ersten Seitenrand 3₁ in den Kabelaufnahmeraum 8 eingeführt, so dass der Innenleiter 4a des zumindest einen ersten Kabels 2a in Draufsicht auf die erste oder zweite Außenlage 3b, 3c also entlang der Längsrichtung 6 unter der zumindest einen ersten Innenleiterkontaktieröffnung 9a angeordnet ist.

In einem sechsten Verfahrensschritt S₆ wird das Innenleiterlotdepot 12a soweit erhitzt, bis dieses schmelzflüssig ist und den Innenleiter 4a des zumindest einen ersten Kabels 2a über eine erste Innenleiterlötverbindung 16a zumindest im Bereich der ersten Innenleiterkontaktieröffnung 9a mit einem ersten Innenleiteranschlussbereich 9a₁ der ersten und/oder zweiten Außenlage 3b, 3c elektrisch leitfähig verbindet.

In einem weiteren optionalen Verfahrensschritt S₇ kann die Anschlussverbindung 1 in ein Gehäuse eingebracht werden, welches beispielsweise aus Kunststoff besteht oder solches umfasst bzw. welches elektrisch leitfähig ist, um die Störemission der Anschlussverbindung 1 zu reduzieren und die Störfestigkeit zu erhöhen. Die Anschlussverbindung 1 wird insbesondere für die Mittelkonsole in Fahrzeugen eingesetzt, um beispielsweise Bildschirmsignale oder USB-Signale an ein dort angebrachtes Display oder eine Steckverbindung zu übertragen oder von dort zu empfangen. Bei einem Fahrzeug handelt es sich insbesondere um ein Kraftfahrzeug, wie ein PKW, LKW, aber auch um einen Zug, ein Flugzeug oder ein Schiff.

An den Steckverbinder kann ein Benutzer beispielsweise einen USB-Datenträger. In diesem Fall befindet sich auf der Plattenanordnung 3 vorzugsweise noch zumindest ein Computerchip, der das Herstellen der USB-Verbindung unterstützt. Der Steckverbinder könnte auch dazu verwendet werden, um ein mobiles Endgerät eines Benutzers aufzuladen. In diesem Fall würden über den Innenleiter 4a des zumindest einen ersten Kabels 2a zumindest ein Ladestrom (Gleichstrom oder Wechselstrom) übertragen werden.

Die Erfindung ist nicht auf die beschriebenen Ausführungsbeispiele beschränkt. Im Rahmen der Erfindung sind alle beschriebenen und/oder gezeichneten Merkmale beliebig miteinander kombinierbar.

## Patentansprüche

1. Anschlussverbindung (1) mit einer Kabelanordnung (2) und einer Plattenanordnung (3) mit den folgenden Merkmalen:
- die Plattenanordnung (3) umfasst zumindest drei in Längsrichtung (6) aufeinander gestapelte Lagen (3a, 3b, 3c), wobei eine Zwischenlage (3a) zwischen einer ersten Außenlage (3b) und einer zweiten Außenlage (3c) angeordnet ist und wobei alle drei Lagen (3a, 3b, 3c) direkt oder mittelbar miteinander verbunden sind;
- die erste Außenlage (3b) und/oder die zweite Außenlage (3c) ist elektrisch leitfähig und die Zwischenlage (3a) umfasst ein dielektrisches Material;
- die Plattenanordnung (3) umfasst zwischen der ersten Außenlage (3b) und der zweiten Außenlage (3c) eine Ausnehmung (7), wodurch ein Kabelaufnahmeraum (8) an einem ersten Seitenrand (3₁) der Plattenanordnung (3) gebildet ist;
- zumindest eine erste Innenleiterkontaktieröffnung (9a) durchsetzt die erste Außenlage (3b) und/oder die zweite Außenlage (3c) und mündet in den Kabelaufnahmeraum (8);
- die Kabelanordnung (2) umfasst zumindest ein erstes Kabel (2a), wobei das erste Kabel (2a) einen Innenleiter (4a) aufweist;
- der Innenleiter (4a) des zumindest einen ersten Kabels (2a) ist an dem ersten Seitenrand (3₁) in den Kabelaufnahmeraum (8) eingeführt und in Längsrichtung (6) versetzt zu der zumindest einen ersten Innenleiterkontaktieröffnung (9a) angeordnet;
- der Innenleiter (4a) des zumindest einen ersten Kabels (2a) ist über eine erste Innenleiterlötverbindung (16a) zumindest im Bereich der ersten Innenleiterkontaktieröffnung (9a) mit einem ersten Innenleiteranschlussbereich (9a₁) der ersten und/oder zweiten Außenlage (3b, 3c) elektrisch leitfähig verlötet;
**gekennzeichnet durch** die folgenden Merkmale:
- die Kabelanordnung (2) umfasst eine Kabelsammel- und Ausrichteinrichtung (13), die aus einem Kunststoff besteht oder einen solchen umfasst und einen Grundköper (14) umfasst;
- die Kabelsammel- und Ausrichteinrichtung (13) ist unverschiebbar an dem zumindest einen ersten Kabel (2a) angeordnet;
- die Kabelsammel- und Ausrichteinrichtung (13) umfasst zumindest eine Befestigungseinrichtung (15), die an dem Grundkörper (14) ausgebildet ist;
- die Befestigungseinrichtung (15) ist dazu ausgebildet, die Kabelsammel- und Ausrichteinrichtung (13) derart an der Plattenanordnung (3) zu befestigen, dass das zumindest eine erste Kabel (2a) der Kabelanordnung (2) lageunveränderlich in dem Kabelaufnahmeraum (8) angeordnet ist.

2. Anschlussverbindung (1) nach Anspruch 1, **gekennzeichnet durch** die folgenden Merkmale:
- die Ausnehmung (7) ist durch ein zerspanendes Verfahren in der Zwischenlage (3a) gebildet; oder
- die erste und die zweite Außenlage (3b, 3c) stehen über die Zwischenlage (3a) an dem ersten Seitenrand über (3₁), wodurch die Ausnehmung (7) und dadurch der Kabelanschlussraum (8) gebildet sind.

3. Anschlussverbindung (1) nach Anspruch 1 oder 2, **gekennzeichnet durch** die folgenden Merkmale:
- bei der Plattenanordnung (3) handelt es sich um eine Leiterplatte; und
- die Zwischenlage (3a) ist dicker als die erste und/oder zweite Außenlage (3b, 3c) alleine oder zusammen.

4. Anschlussverbindung (1) nach einem der vorherigen Ansprüche, **gekennzeichnet durch** das folgende Merkmal:
- die erste Innenleiterlötverbindung (16a) ist aus einem aufgeschmolzenen ersten Innenleiterlotdepot (12a) gebildet, wobei das erste Innenleiterlotdepot (12a):
a) in der zumindest einen ersten Innenleiterkontaktieröffnung (9a) angeordnet ist; und/oder
b) an dem Innenleiter (4a) des zumindest einen ersten Kabels (2a) unterhalb der zumindest einen ersten Innenleiterkontaktieröffnung (9a) angeordnet ist.

5. Anschlussverbindung (1) nach einem der vorherigen Ansprüche, **gekennzeichnet durch** die folgenden Merkmale:
- die Plattenanordnung (3) umfasst noch:
a) eine erste Decklage (3d), die auf der ersten Außenlage (3b) angeordnet ist, sodass die erste Außenlage (3b) zwischen der Zwischenlage (3a) und der ersten Decklage (3d) liegt, wobei die erste Innenleiterkontaktieröffnung (9a) die erste Decklage (3d) durchsetzt;
und/oder
b) eine zweite Decklage (3e), die auf der zweiten Außenlage (3c) angeordnet ist, sodass die zweite Außenlage (3c) zwischen der Zwischenlage (3a) und der zweiten Decklage (3e) liegt, wobei die erste Innenleiterkontaktieröffnung (9a) die zweite Decklage (3e) durchsetzt;
und/oder
- die Ausnehmung (7) erstreckt sich nur über einen Teil der Dicke der Zwischenlage (3a), wodurch die Zwischenlage (3a) zwei voneinander beabstandete Bereiche (11a, 11b) umfasst, die an der ersten und zweiten Außenlage (3b, 3c) angeordnet sind und den Kabelaufnahmeraum (8) in Längsrichtung (6) begrenzen;
die erste Innenleiterkontaktieröffnung (9a) durchsetzt den ersten und/oder zweiten Bereich (11a, 11b) der Zwischenlage (3a);
und/oder
- eine Innenwandung (10) der ersten Innenleiterkontaktieröffnung (9a) ist mit einer Metallschicht galvanisiert.

6. Anschlussverbindung (1) nach einem der vorherigen Ansprüche, **gekennzeichnet durch** die folgenden Merkmale:
- das erste Kabel (2a) der Kabelanordnung (2) umfasst noch einen Außenleiter (4d), der von dem Innenleiter (4a) durch ein Dielektrikum (4b) galvanisch getrennt ist;
- zumindest eine erste Außenleiterkontaktieröffnung (18a) durchsetzt die erste Außenlage (3b) und/oder die zweite Außenlage (3c) und mündet in den Kabelaufnahmeraum (8);
- die erste Außenleiterkontaktieröffnung (18a) ist näher an dem ersten Seitenrand (3₁) angeordnet als die erste Innenleiterkontaktieröffnung (9a);
- der Außenleiter (4d) des zumindest einen ersten Kabels (2a) ist an dem ersten Seitenrand (3₁) in den Kabelaufnahmeraum (8) eingeführt und in Längsrichtung (6) versetzt zu der zumindest einen ersten Außenleiterkontaktieröffnung (18a) angeordnet;
- der Außenleiter (4d) des zumindest einen ersten Kabels (2a) ist über eine erste Außenleiterlötverbindung (20a) zumindest im Bereich der ersten Außenleiterkontaktieröffnung (18a) mit einem ersten Außenleiteranschlussbereich (18a₁) der ersten und/oder zweiten Außenlage (3b, 3c) elektrisch leitfähig verlötet;
- der erste Innenleiteranschlussbereich (9a₁) ist galvanisch von dem ersten Außenleiteranschlussbereich (18a₁) getrennt.

7. Anschlussverbindung (1) nach Anspruch 6, **gekennzeichnet durch** die folgenden Merkmale:
- der Außenleiter (4d) des zumindest einen ersten Kabels (2a) umfasst ein Schirmgeflecht;
- die Kabelanordnung (2) umfasst zumindest eine erste Metallfolie (5);
- die erste Metallfolie (5) ist um das Schirmgeflecht herum angeordnet.

8. Anschlussverbindung (1) nach einem der vorherigen Ansprüche, **gekennzeichnet durch** die folgenden Merkmale:
- die Kabelanordnung (2) umfasst zumindest ein zweites Kabel (2b) mit einem Innenleiter (4a);
- die Kabel (2a, 2b) der Kabelanordnung (2) sind nebeneinander angeordnet;
- zumindest eine zweite Innenleiterkontaktieröffnung (9b) durchsetzt die erste Außenlage (3b) und/oder die zweite Außenlage (3c) und mündet in den Kabelaufnahmeraum (8);
- der Innenleiter (4a)des zumindest einen zweiten Kabels (2b) ist an dem ersten Seitenrand (3₁) in den Kabelaufnahmeraum (8) eingeführt und in Längsrichtung (6) versetzt zu der zumindest einen zweiten Innenleiterkontaktieröffnung (9b) angeordnet;
- der Innenleiter (4a) des zumindest einen zweiten Kabels (2b) ist über eine zweite Innenleiterlötverbindung zumindest im Bereich der zweiten Innenleiterkontaktieröffnung (9b) mit einem zweiten Innenleiteranschlussbereich (9b₁) der ersten und/oder zweiten Außenlage (3b, 3c) elektrisch leitfähig verlötet;
- der erste Innenleiteranschlussbereich (9a₁) und der zweite Innenleiteranschlussbereich (9b₁) sind galvanisch voneinander getrennt.

9. Anschlussverbindung (1) nach Anspruch 8, **gekennzeichnet durch** die folgenden Merkmale:
- das zumindest eine zweite Kabel (2b) der Kabelanordnung (2) umfasst noch einen Außenleiter (4d), der von dem Innenleiter (4a) durch ein Dielektrikum (4b) galvanisch getrennt ist;
- zumindest eine zweite Außenleiterkontaktieröffnung (18b) durchsetzt die erste Außenlage (3b) und/oder die zweite Außenlage (3c) und mündet in den Kabelaufnahmeraum (8);
- die zweite Außenleiterkontaktieröffnung (18b) ist näher an dem ersten Seitenrand (3₁) angeordnet als die zweite Innenleiterkontaktieröffnung (9b);
- der Außenleiter (4d) des zumindest einen zweiten Kabels (2b) ist an dem ersten Seitenrand (3₁) in den Kabelaufnahmeraum (8) eingeführt und in Längsrichtung (6) versetzt zu der zumindest einen zweiten Außenleiterkontaktieröffnung (18b) angeordnet;
- der Außenleiter (4d) des zumindest einen zweiten Kabels (2b) ist über eine zweite Außenleiterlötverbindung zumindest im Bereich der zweiten Außenleiterkontaktieröffnung (18b) mit einem zweiten Außenleiteranschlussbereich der ersten und/oder zweiten Außenlage (3b, 3c) elektrisch leitfähig verlötet;
- der zweite Innenleiteranschlussbereich (9b₁) ist galvanisch von dem zweiten Außenleiteranschlussbereich getrennt.

10. Anschlussverbindung (1) nach einem der vorherigen Ansprüche, **gekennzeichnet durch** die folgenden Merkmale:
- die Befestigungseinrichtung (13) umfasst einen ersten und einen zweiten Rasthaken (15b₁, 15b₂);
- der erste und der zweite Rasthaken (15b₁, 15b₂) entspringen an verschiedenen Bereichen des Grundkörpers (14) und verlaufen in Richtung eines zweiten und eines dritten Seitenrands (3₂, 3₃) der Plattenanordnung (3), wobei der zweite und der dritte Seitenrand (3₂, 3₃) der Plattenanordnung (3) unter einem Winkel von vorzugsweise 90° auf unterschiedliche Enden des ersten Seitenrands (3₁) zulaufen;
- eine erste Rastöffnung (17a) ist an dem zweiten Seitenrand (3₂) ausgebildet und eine zweite Rastöffnung (17b) ist an dem dritten Seitenrand (3₃) ausgebildet;
- der erste Rasthaken (15b₁) greift in die erste Rastöffnung (17a) ein und der zweite Rasthaken (15b₂) greift in die zweite Rastöffnung (17b) ein.

11. Anschlussverbindung (1) nach Anspruch 10, **gekennzeichnet durch** die folgenden Merkmale:
- in der Plattenanordnung (3) sind durch die Rastöffnungen (17a, 17b) Auflageschultern gebildet;
- die Rasthaken (15b₁, 15b₂) hintergreifen die jeweilige Auflageschulter.

12. Anschlussverbindung (1) nach Anspruch 10 oder 11, **gekennzeichnet durch** das folgende Merkmal:
- ein vorderer Teil der Rasthaken (15b₁, 15b₂) ist L-förmig und vergrößert sich zumindest teilweise schräg oder konisch in Richtung des Grundkörpers (14).

13. Anschlussverbindung (1) nach einem der vorherigen Ansprüche, **gekennzeichnet durch** die folgenden Merkmale:
- die Befestigungseinrichtung (15) umfasst eine erste und einen zweite Befestigungszunge (15c₁, 15c₂);
- die Plattenanordnung (3) ist mit ihrem ersten Seitenrand (3₁) zwischen den zwei Befestigungszungen (15c₁, 15c₂) angeordnet, wobei die erste Befestigungszunge (15c₁) auf der ersten Außenlage (3b) aufliegt und wobei die zweite Befestigungszunge (15c₂) auf der zweiten Außenlage (3c) aufliegt;
- die Befestigungseinrichtung (15) umfasst zumindest einen oder zumindest zwei Befestigungsstifte (15d), wobei der zumindest eine oder die zumindest zwei Befestigungsstifte (15d) durch die zwei Befestigungszungen (15c₁, 15c₂) und die Plattenanordnung (3) verlaufen, wodurch ein Abziehen der Kabelanordnung (2) von der Plattenanordnung (3) verhindert wird; und/oder
zwischen der ersten Befestigungszunge (15c₁) und der ersten Außenlage (3b) ist eine erste Kugelrastung ausgebildet und/oder zwischen der zweiten Befestigungszunge (15c₂) und der zweiten Außenlage (3c) ist eine zweite Kugelrastung ausgebildet.

14. Anschlussverbindung (1) nach einem der vorherigen Ansprüche, **gekennzeichnet durch** die folgenden Merkmale:
- die Befestigungseinrichtung (15) umfasst zumindest einen Trennsteg (15a), der von dem Grundkörper (14) aus in Richtung der Plattenanordnung (3) verläuft und in dem Kabelaufnahmeraum (8) endet;
- das zumindest eine erste Kabel (2a) ist dabei von dem zumindest einen oder von zwei Trennstegen (15a) flankiert;
- der zumindest eine Trennsteg (15a) verläuft dabei in etwa parallel zu dem zumindest einen ersten Kabel (2a).

15. Verfahren zur Herstellung einer Anschlussverbindung (1) zwischen einer Plattenanordnung (3) und einer Kabelanordnung (2) mit den folgenden Verfahrensschritten:
- Herstellen (S₁) einer Plattenanordnung (3), die zumindest drei in Längsrichtung (6) aufeinander gestapelte Lagen (3a, 3b, 3c) umfasst, wobei eine dielektrische Zwischenlage (3a) zwischen einer ersten Außenlage (3b) und einer zweiten Außenlage (3c) angeordnet ist, wobei die erste Außenlage (3b) und/oder die zweite Außenlage (3c) elektrisch leitfähig ist, wobei eine Ausnehmung (7) zwischen der ersten Außenlage (3b) und der zweiten Außenlage (3c) eingebracht wird, wodurch ein Kabelaufnahmeraum (8) an einem ersten Seitenrand (3₁) der Plattenanordnung (3) gebildet ist;
- Einbringen (S₂) zumindest einer ersten Innenleiterkontaktieröffnung (9a) in die Plattenanordnung (3), wobei diese die erste Außenlage (3b) und/oder die zweite Außenlage (3c) durchsetzt und in den Kabelaufnahmeraum (8) mündet;
- Freilegen (S₃) des Innenleiters (4a) des zumindest einen ersten Kabels (2a) der Kabelanordnung (2);
- Verwenden einer Kabelsammel- und Ausrichteinrichtung (13), die aus einem Kunststoff besteht oder einen solchen umfasst und ferner einen Grundköper (14) und eine Befestigungseinrichtung (15) umfasst, die an dem Grundkörper (14) ausgebildet ist;
- Unverschiebliches Anordnen der Kabelsammel- und Ausrichteinrichtung (13) an dem zumindest einen ersten Kabel (2a);
- Anbringen (S₄) zumindest eines ersten Innenleiterlotdepots (12a) in die zumindest eine erste Innenleiterkontaktieröffnung (9a) und/oder an den freigelegten Innenleiter (4a) des zumindest einen ersten Kabels (2a) der Kabelanordnung (2);
- Einführen (S₅) des Innenleiters (4a) des zumindest einen ersten Kabels (2a) an dem ersten Seitenrand (3₁) in den Kabelaufnahmeraum (8) derart, dass der Innenleiter (4a) des zumindest einen ersten Kabels (2a) in Längsrichtung (6) versetzt zu der zumindest einen ersten Innenleiterkontaktieröffnung (9a) angeordnet ist, wobei die Befestigungseinrichtung (15) dazu ausgebildet ist, die Kabelsammel- und Ausrichteinrichtung (13) derart an der Plattenanordnung (3) zu befestigen, dass das zumindest eine erste Kabel (2a) der Kabelanordnung (2) lageunveränderlich in dem Kabelaufnahmeraum (8) angeordnet ist; und
- Erhitzen (S₆) des zumindest einen ersten Innenleiterlotdepots (12a) bis dieses schmelzflüssig wird und den Innenleiter (4a) des zumindest einen ersten Kabels (2a) über eine erste Innenleiterlötverbindung (16a) zumindest im Bereich der ersten Innenleiterkontaktieröffnung (9a) mit einem ersten Innenleiteranschlussbereich (9a₁) der ersten und/oder zweiten Außenlage (3b, 3c) elektrisch leitfähig verbindet.

## Claims

1. Connection (1) with a cable assembly (2) and a plate assembly (3), having the following characteristics:
- the plate assembly (3) comprises at least three layers (3a, 3b, 3c) which are stacked one on top of another in the longitudinal direction (6), wherein an intermediate layer (3a) is arranged between a first outer layer (3b) and a second outer layer (3c), and wherein all three layers (3a, 3b, 3c) are mutually connected, whether directly or indirectly;
- the first outer layer (3b) and/or the second outer layer (3c) are/is electrically conductive, and the intermediate layer (3a) is comprised of a dielectric material;
- the plate assembly (3) comprises a cut-out (7) between the first outer layer (3b) and the second outer layer (3c), by means of which a cable location space (8) is constituted on a first lateral edge (3₁) of the plate assembly (3);
- at least one first inner conductor contacting opening (9a) penetrates the first outer layer (3b) and/or the second outer layer (3c), and terminates in the cable location space (8);
- the cable assembly (2) comprises at least one first cable (2a), wherein the first cable (2a) has an inner conductor (4a);
- the inner conductor (4a) of the at least one first cable (2a) is introduced into the cable location space (8) at the first lateral edge (3₁) and is offset, in the longitudinal direction (6), in relation to the at least one first inner conductor contacting opening (9a);
- the inner conductor (4a) of the at least one first cable (2a), by means of a first inner conductor soldered connection (16a), at least in the region of the first inner conductor contacting opening (9a), is soldered to a first inner conductor connection region (9a₁) of the first and/or second outer layer (3b, 3c) in an electrically conductive manner;
**characterized by** the following characteristics:
- the cable assembly (2) comprises a cable bundling and orientation device (13) which is comprised of plastic, or incorporates such a material, and incorporates a base component (14);
- the cable bundling and orientation device (13) is arranged on the at least one cable (2a) in a non-displaceable manner;
- the cable bundling and orientation device (13) comprises at least one fixing device (15), which is configured on the base component (14);
- the fixing device (15) is designed to secure the cable bundling and orientation device (13) on the plate assembly (3) such that the at least one first cable (2a) of the cable assembly (2) is arranged in the cable location space (8) in an immoveable manner.

2. Connection (1) according to Claim 1, **characterized by** the following characteristics:
- the cut-out (7) is formed in the intermediate layer (3a) by a machining method; or
- the first and the second outer layers (3b, 3c) project beyond the intermediate layer (3a) at the first lateral edge (3₁), thereby constituting the cut-out (7), and thus the cable location space (8).

3. Connection (1) according to Claim 1 or Claim 2, **characterized by** the following characteristics:
- the plate assembly (3) is a circuit board; and
- the intermediate layer (3a) is thicker than the first and/or second outer layers (3b, 3c), either individually or in combination.

4. Connection (1) according to one of the preceding claims, **characterized by** the following characteristic:
- the first inner conductor soldered connection (16a) is constituted by a melted first inner conductor solder deposit (12a), wherein the first inner conductor solder deposit (12a):
a) is arranged in the at least one first inner conductor contacting opening (9a); and/or
b) is arranged on the inner conductor (4a) of the at least one first cable (2a), below the at least one first inner conductor contacting opening (9a).

5. Connection (1) according to one of the preceding claims, **characterized by** the following characteristics:
- the plate assembly (3) further comprises:
a) a first cover layer (3d), which is arranged on the first outer layer (3b), such that the first outer layer (3b) lies between the intermediate layer (3a) and the first cover layer (3d), wherein the first inner conductor contacting opening (9a) penetrates the first cover layer (3d);
and/or
b) a second cover layer (3e), which is arranged on the second outer layer (3c), such that the second outer layer (3c) lies between the intermediate layer (3a) and the second cover layer (3e), wherein the first inner conductor contacting opening (9a) penetrates the second cover layer (3e);
and/or
- the cut-out (7) only extends over part of the thickness of the intermediate layer (3a), as a result of which the intermediate layer (3a) is comprised of two mutually spaced regions (11a, 11b), which are arranged on the first and second outer layers (3b, 3c) and delimit the cable location space (8) in the longitudinal direction (6);
the first inner conductor contacting opening (9a) penetrates the first and/or second region (11a, 11b) of the intermediate layer (3a);
and/or
- an inner wall (10) of the first inner conductor contacting opening (9a) is galvanized by the application of a metal coating.

6. Connection (1) according to one of the preceding claims, **characterized by** the following characteristics:
- the first cable (2a) of the cable assembly (2) further comprises an outer conductor (4d), which is galvanically isolated from the inner conductor (4a) by a dielectric (4b);
- at least one first outer conductor contacting opening (18a) penetrates the first outer layer (3b) and/or the second outer layer (3c) and terminates in the cable location space (8);
- the first outer conductor contacting opening (18a) is arranged closer to the first lateral edge (3₁) than the first inner conductor contacting opening (9a);
- the outer conductor (4d) of the at least one first cable (2a) is introduced into the cable location space (8) at the first lateral edge (3₁) and is offset, in the longitudinal direction (6), in relation to the at least one first outer conductor contacting opening (18a);
- the outer conductor (4d) of the at least one first cable (2a), by means of a first outer conductor soldered connection (20a), at least in the region of the first outer conductor contacting opening (18a), is soldered to a first outer conductor connection region (18a₁) of the first and/or second outer layer (3b, 3c) in an electrically conductive manner;
- the first inner conductor connection region (9a₁) is galvanically isolated from the first outer conductor connection region (18a₁).

7. Connection (1) according to Claim 6, **characterized by** the following characteristics:
- the outer conductor (4d) of the at least one first cable (2a) comprises a braided screen;
- the cable assembly (2) comprises at least one first metal film (5);
- the first metal film (5) is arranged around the braided screen.

8. Connection (1) according to one of the preceding claims, **characterized by** the following characteristics:
- the cable assembly (2) comprises at least one second cable (2b) having an inner conductor (4a);
- the cables (2a, 2b) of the cable assembly (2) are arranged adjacently to one another;
- at least one second inner conductor contacting opening (9b) penetrates the first outer layer (3b) and/or the second outer layer (3c), and terminates in the cable location space (8);
- the inner conductor (4a) of the at least one second cable (2b) is introduced into the cable location space (8) at the first lateral edge (3₁) and is offset, in the longitudinal direction (6), in relation to the at least one second inner conductor contacting opening (9b);
- the inner conductor (4a) of the at least one second cable (2b), by means of a second inner conductor soldered connection, at least in the region of the second inner conductor contacting opening (9b), is soldered to a second inner conductor connection region (9b₁) of the first and/or second outer layer (3b, 3c) in an electrically conductive manner;
- the first inner conductor connection region (9a₁) and the second inner conductor connection region (9b₁) are mutually galvanically isolated.

9. Connection (1) according to Claim 8, **characterized by** the following characteristics:
- the at least one second cable (2b) of the cable assembly (2) further comprises an outer conductor (4d), which is galvanically isolated from the inner conductor (4a) by a dielectric (4b);
- at least one second outer conductor contacting opening (18b) penetrates the first outer layer (3b) and/or the second outer layer (3c) and terminates in the cable location space (8);
- the second outer conductor contacting opening (18b) is arranged closer to the first lateral edge (3₁) than the second inner conductor contacting opening (9b);
- the outer conductor (4d) of the at least one second cable (2b) is introduced into the cable location space (8) at the first lateral edge (3₁) and is offset, in the longitudinal direction (6), in relation to the at least one second outer conductor contacting opening (18b);
- the outer conductor (4d) of the at least one second cable (2b), by means of a second outer conductor soldered connection, at least in the region of the second outer conductor contacting opening (18b), is soldered to a second outer conductor connection region of the first and/or second outer layer (3b, 3c) in an electrically conductive manner;
- the second inner conductor connection region (9b₁) is galvanically isolated from the second outer conductor connection region.

10. Connection (1) according to one of the preceding claims, **characterized by** the following characteristics:
- the fixing device (13) comprises a first and a second latching hook (15b₁, 15b₂);
- the first and second latching hooks (15b₁, 15b₂) originate at different regions of the base component (14), and are oriented in the direction of a second and third lateral edge (3₂, 3₃) of the plate assembly (3), wherein the second and third lateral edges (3₂, 3₃) of the plate assembly (3) are routed to different ends of the first lateral edge (3₁), at an angle of preferably 90°;
- a first latching opening (17a) is configured on the second lateral edge (3₂) and a second latching opening (17b) is configured on the third lateral edge (3₃);
- the first latching hook (15b₁) engages in the first latching opening (17a), and the second latching hook (15b₂) engages in the second latching opening (17b).

11. Connection (1) according to Claim 10, **characterized by** the following characteristics:
- in the plate assembly (3), support shoulders are constituted by the latching openings (17a, 17b);
- the latching hooks (15b₁, 15b₂) execute reverse interlocking with the respective support shoulder.

12. Connection (1) according to Claim 10 or 11, **characterized by** the following characteristic:
- a front part of the latching hooks (15b₁, 15b₂) is L-shaped, and at least partially expands obliquely or conically in the direction of the base component (14).

13. Connection (1) according to one of the preceding claims, **characterized by** the following characteristics:
- the fixing device (15) comprises a first and a second fixing tab (15c₁, 15c₂);
- the plate assembly (3), at its first lateral edge (3₁), is arranged between the two fixing tabs (15c₁, 15c₂), such that the first fixing tab (15c₁) engages with the first outer layer (3b), and the second fixing tab (15c₂) engages with the second outer layer (3c);
- the fixing device (15) comprises at least one or at least two fixing studs (15d), wherein the at least one or the at least two fixing studs (15d) are routed through the two fixing tabs (15c₁, 15c₂) and the plate assembly (3), as a result of which any detachment of the cable assembly (2) from the plate assembly (3) is prevented;
and/or
a first ball catch is configured between the first fixing tab (15c₁) and the first outer layer (3b), and/or
a second ball catch is configured between the second fixing tab (15c2) and the second outer layer (3c).

14. Connection (1) according to one of the preceding claims, **characterized by** the following characteristics:
- the fixing device (15) comprises at least one separating web (15a), which is oriented from the base component (14) in the direction of the plate assembly (3), and terminates in the cable location space (8);
- the at least one first cable (2a) is flanked by the at least one or two separating webs (15a);
- the at least one separating web (15a) is oriented approximately in parallel with the at least one first cable (2a).

15. Method for producing a connection (1) between a plate assembly (3) and a cable assembly (2), comprising the following process steps:
- production (S₁) of a plate assembly (3), which comprises at least three layers (3a, 3b, 3c) which are stacked one on top of another in the longitudinal direction (6), wherein a dielectric intermediate layer (3a) is provided between a first outer layer (3b) and a second outer layer (3c), wherein the first outer layer (3b) and/or the second outer layer (3c) is (are) electrically conductive, wherein a cut-out (7) is incorporated between the first outer layer (3b) and the second outer layer (3c), by means of which a cable location space (8) is constituted on a first lateral edge (3₁) of the plate assembly (3);
- incorporation (S₂) of at least one first inner conductor contacting opening (9a) in the plate assembly (3), wherein the former penetrates the first outer layer (3b) and/or the second outer layer (3c), and terminates in the cable location space (8);
- exposure (S₃) of the inner conductor (4a) of the at least one first cable (2a) of the cable assembly (2);
- employment of a cable bundling and orientation device (13), which is comprised of a plastic, or incorporates such a material, and further incorporates a base component (14) and a fixing device (15), which is configured on the base component (14);
- non-displaceable arrangement of the cable bundling and orientation device (13) on the at least one first cable (2a);
- introduction (S₄) of at least one first inner conductor solder deposit (12a) into the at least one first inner conductor contacting opening (9a) and/or to the exposed inner conductor (4a) of the at least one first cable (2a) of the cable assembly (2);
- introduction (S₅) of the inner conductor (4a) of the at least one first cable (2a) into the cable location space (8) at the first lateral edge (3₁), such that the inner conductor (4a) of the at least one first cable (2a) is offset, in the longitudinal direction (6), in relation to the at least one first inner conductor contacting opening (9a), wherein the fixing device (15) is configured to secure the cable bundling and orientation device (13) on the plate assembly (3) such that the at least one first cable (2a) of the cable assembly (2) is arranged in the cable location space (8) in an immoveable manner; and
- heating (S₆) of the at least one first inner conductor solder deposit (12a) until it melts, and connection of the inner conductor (4a) of the least one first cable (2a), by means of a first inner conductor soldered connection (16a), at least in the region of the first inner conductor contacting opening (9a), to a first inner conductor connection region (9a₁) of the first and/or second outer layer (3b, 3c) in an electrically conductive manner.

## Revendications

1. Raccord de connexion (1), pourvu d'un ensemble de câbles (2) et d'un ensemble de plaques (3), présentant les caractéristiques suivantes :
- l'ensemble de plaques (3) comprend au moins trois couches (3a, 3b, 3c) empilées les unes sur les autres dans la direction longitudinale (6), une couche intermédiaire (3a) étant placée entre une première couche extérieure (3b) et une deuxième couche extérieure (3c) et toutes les trois couches (3a, 3b, 3c) étant assemblées directement ou indirectement les unes aux autres ;
- la première couche extérieure (3b) et/ou la deuxième couche extérieure (3c) est conductrice d'électricité et la couche intermédiaire (3a) comprend une matière diélectrique ;
- l'ensemble de plaques (3) comprend entre la première couche extérieure (3b) et la deuxième couche extérieure (3c) un évidement (7), par lequel est créé un espace de logement de câbles (8) sur un premier bord latéral (3₁) de l'ensemble de plaques (3) ;
- au moins un premier orifice de contact d'un conducteur interne (9a) traverse la première couche extérieure (3b) et/ou la deuxième couche extérieure (3c) et débouche dans l'espace de logement de câbles (8) ;
- l'ensemble de câbles (2) comprend au moins un premier câble (2a), le premier câble (2a) comportant un conducteur interne (4a) ;
- le conducteur interne (4a) de l'au moins un premier câble (2a) est inséré sur le premier bord latéral (3₁) dans l'espace de logement de câbles (8) et placé avec un décalage en direction longitudinale (6) par rapport à l'au moins un premier orifice de contact d'un conducteur interne (9a) ;
- le conducteur interne (4a) de l'au moins un premier câble (2a) est brasé de manière conductrice d'électricité par l'intermédiaire d'un premier assemblage par brasage de conducteur interne (16a), au moins dans la zone du premier orifice de contact d'un conducteur interne (9a) avec une première zone de connexion de conducteur interne (9a₁) de la première et/ou deuxième couche extérieure (3b, 3c) ;
**caractérisé par** les caractéristiques suivantes :
- l'ensemble de câbles (2) comprend un système de collecte et d'alignement des câbles (13), qui est constitué d'une matière plastique ou en comprend une telle et qui comporte un corps de base (14) ;
- le système de collecte et d'alignement des câbles (13) est placé de manière indéplaçable sur l'au moins un premier câble (2a) ;
- le système de collecte et d'alignement des câbles (13) comprend au moins un système de fixation (15), qui est conçu sur le corps de base (14) ;
- le système de fixation (15) est conçu pour fixer le système de collecte et d'alignement des câbles (13) sur l'ensemble de plaques (3), de telle sorte qu'au moins un premier câble (2a) de l'ensemble de câbles (2) soit placé de manière indéplaçable dans l'espace de logement de câbles (8).

2. Raccord de connexion (1) selon la revendication 1, **caractérisé par** les caractéristiques suivantes :
- l'évidement (7) est créé par un procédé d'enlèvement de copeaux dans la couche intermédiaire (3a) ; ou
- les première et deuxième couches extérieures (3b, 3c) débordent au-delà de la couche intermédiaire (3a) sur le premier bord latéral (3₁), suite à quoi est créé l'évidement (7) et ainsi l'espace de connexion de câbles (8).

3. Raccord de connexion (1) selon la revendication 1 ou 2, **caractérisé par** les caractéristiques suivantes :
- l'ensemble de plaques (3) est une carte de circuit imprimé ; et
- la couche intermédiaire (3a) est plus épaisse que la première et/ou la deuxième couche extérieure (3b, 3c), seules ou en commun.

4. Raccord de connexion (1) selon l'une quelconque des revendications précédentes, **caractérisé par** la caractéristique suivante :
- le premier assemblage par brasage de conducteur interne (16a) est créé sur un premier dépôt de brasure de conducteur interne (12a), le premier dépôt de brasure de conducteur interne (12a) :
a) étant placé dans l'au moins un premier orifice de contact d'un conducteur interne (9a) ; et/ou
b) étant placé sur le conducteur interne (4a) de l'au moins un premier câble (2a), en dessous de l'au moins un premier orifice de contact d'un conducteur interne (9a).

5. Raccord de connexion (1) selon l'une quelconque des revendications précédentes, **caractérisé par** les caractéristiques suivantes :
- l'ensemble de plaques (3) comprend encore :
a) une première couche de couverture (3d), qui est placée sur la première couche extérieure (3b), de telle sorte que la première couche extérieure (3b) se situe entre la couche intermédiaire (3a) et la première couche de couverture (3d), le premier orifice de contact de conducteur interne (9a) traversant la première couche de couverture (3d) ;
et/ou
b) une deuxième couche de couverture (3e), qui est placée sur la deuxième couche extérieure (3c), de telle sorte que la deuxième couche extérieure (3c) se situe entre la couche intermédiaire (3a) et la deuxième couche de couverture (3e), le premier orifice de contact de conducteur interne (9a) traversant la deuxième couche de couverture (3e) ;
et/ou
- l'évidement (7) ne s'étend que sur une partie de l'épaisseur de la couche intermédiaire (3a), suite à quoi la couche intermédiaire (3a) comprend deux zones (11a, 11b) écartées l'une de l'autre, qui sont placées sur la première et la deuxième couche extérieure (3b, 3c) et qui délimitent l'espace de logement de câbles (8) dans la direction longitudinale (6) ;
le premier orifice de contact d'un conducteur interne (9a) traverse la première et/ou la deuxième zone (11a, 11b) de la couche intermédiaire (3a) ;
et/ou
- une paroi intérieure (10) du premier orifice de contact d'un conducteur interne (9a) est galvanisée avec une couche métallique.

6. Raccord de connexion (1) selon l'une quelconque des revendications précédentes, **caractérisé par** les caractéristiques suivantes :
- le premier câble (2a) de l'ensemble de câbles (2) comprend encore un conducteur externe (4d), qui est galvaniquement séparé du conducteur interne (4a) par un diélectrique (4b) ;
- au moins un premier orifice de contact de conducteur externe (18a) traverse la première couche extérieure (3b) et/ou la deuxième couche extérieure (3c) et débouche dans l'espace de logement de câbles (8) ;
- le premier orifice de contact de conducteur externe (18a) est placé de manière plus proche du premier bord latéral (3₁) que le premier orifice de contact d'un conducteur interne (9a) ;
- le conducteur externe (4d) de l'au moins un premier câble (2a) est inséré sur le premier bord latéral (3₁) dans l'espace de logement de câbles (8) et placé en étant décalé dans la direction longitudinale (6) par rapport à l'au moins un premier orifice de contact de conducteur externe (18a) ;
- le conducteur externe (4d) de l'au moins un premier câble (2a) est brasé de manière conductrice d'électricité, par l'intermédiaire d'un premier assemblage par brasage de conducteur externe (20a), au moins dans la zone du premier orifice de contact de conducteur externe (18a) avec une première zone de connexion de conducteur externe (18a₁) de la première et/ou de la deuxième couche extérieure (3b, 3c) ;
- la première zone de connexion de conducteur interne (9a₁) est galvaniquement séparée de la première zone de connexion de conducteur externe (18a₁).

7. Raccord de connexion (1) selon la revendication 6, **caractérisé par** les caractéristiques suivantes :
- le conducteur externe (4d) de l'au moins un premier câble (2a) comprend une tresse de blindage ;
- l'ensemble de câbles (2) comprend au moins un premier film métallique (5) ;
- le premier film métallique (5) est placé autour de la tresse de blindage.

8. Raccord de connexion (1) selon l'une quelconque des revendications précédentes, **caractérisé par** les caractéristiques suivantes :
- l'ensemble de câbles (2) comprend au moins un deuxième câble (2b) pourvu d'un conducteur interne (4a) ;
- les câbles (2a, 2b) de l'ensemble de câbles (2) sont placés côte à côte ;
- au moins un deuxième orifice de contact d'un conducteur interne (9b) traverse la première couche extérieure (3b) et/ou la deuxième couche extérieure (3c) et débouche dans l'espace de logement de câbles (8) ;
- le conducteur interne (4a) de l'au moins un deuxième câble (2b) est inséré sur le premier bord latéral (3₁) dans l'espace de logement de câbles (8) et placé en décalage dans la direction longitudinale (6) par rapport à l'au moins un deuxième orifice de contact d'un conducteur interne (9b) ;
- le conducteur interne (4a) de l'au moins un deuxième câble (2b) est brasé de manière conductrice d'électricité par l'intermédiaire d'un deuxième assemblage par brasage de conducteur interne, au moins dans la zone du deuxième orifice de contact d'un conducteur interne (9b) avec une deuxième zone de connexion de conducteur interne (9b₁) de la première et/ou de la deuxième couche extérieure (3b, 3c) ;
- la première zone de connexion de conducteur interne (9a₁) et la deuxième zone de connexion de conducteur interne (9b₁) sont galvaniquement séparées l'une de l'autre.

9. Raccord de connexion (1) selon la revendication 8, **caractérisé par** les caractéristiques suivantes :
- l'au moins un deuxième câble (2b) de l'ensemble de câbles (2) comprend encore un conducteur externe (4d), qui est galvaniquement séparé du conducteur interne (4a) par un diélectrique (4b) ;
- au moins un deuxième orifice de contact de conducteur externe (18b) traverse la première couche extérieure (3b) et/ou la deuxième couche extérieure (3c) et débouche dans l'espace de logement de câbles (8) ;
- le deuxième orifice de contact de conducteur externe (18b) est placé de manière plus proche du premier bord latéral (3₁) que le deuxième orifice de contact d'un conducteur interne (9b) ;
- le conducteur externe (4d) de l'au moins un deuxième câble (2b) est inséré sur le premier bord latéral (3₁) dans l'espace de logement de câbles (8) et placé en décalage dans la direction longitudinale (6) par rapport à l'au moins un deuxième orifice de contact de conducteur externe (18b) ;
- le conducteur externe (4d) de l'au moins un deuxième câble (2b) est brasé de manière conductrice d'électricité, par l'intermédiaire d'un deuxième assemblage par brasage de conducteur externe, au moins dans la zone du deuxième orifice de contact de conducteur externe (18b) avec une deuxième zone de connexion de conducteur externe de la première et/ou de la deuxième couche extérieure (3b, 3c) ;
- la deuxième zone de connexion de conducteur interne (9b₁) est galvaniquement séparée de la deuxième zone de connexion de conducteur externe.

10. Raccord de connexion (1) selon l'une quelconque des revendications précédentes, **caractérisé par** les caractéristiques suivantes :
- le système de fixation (13) comprend un premier et un deuxième crochet d'encliquetage (15b₁, 15b₂) ;
- le premier et le deuxième crochet d'encliquetage (15b₁, 15b₂) dérivent sur différentes zones du corps de base (14) et s'écoulent dans la direction d'un deuxième et d'un troisième bord latéral (3₂, 3₃) de l'ensemble de plaques (3), le deuxième et troisième bord latéral (3₂, 3₃) de l'ensemble de plaques (3) convergeant sous un angle de 90° de préférence vers différentes extrémités du premier bord latéral (3₁) ;
- un premier orifice d'encliquetage (17a) est conçu sur le deuxième bord latéral (3₂) et un deuxième orifice d'encliquetage(17b) est conçu sur le troisième bord latéral (3₃) ;
- le premier crochet d'encliquetage (15b₁) s'engage dans le premier orifice d'encliquetage (17a) et le deuxième crochet d'encliquetage (15b₂) s'engage dans le deuxième orifice d'encliquetage (17b).

11. Raccord de connexion (1) selon la revendication 10, **caractérisé par** les caractéristiques suivantes :
- dans l'ensemble de plaques (3), des épaulements d'appui sont créés par les orifices d'encliquetage (17a, 17b) ;
- les crochets d'encliquetage (15b₁, 15b₂) s'accrochent par l'arrière dans l'épaulement d'appui respectif.

12. Raccord de connexion (1) selon la revendication 10 ou 11, **caractérisé par** la caractéristique suivante :
- une partie avant des crochets d'encliquetage (15b₁, 15b₂) est en forme de L et s'agrandit au moins en partie en oblique ou en forme de cône dans la direction du corps de base (14).

13. Raccord de connexion (1) selon l'une quelconque des revendications précédentes, **caractérisé par** les caractéristiques suivantes :
- le système de fixation (15) comprend une première et une deuxième languette de fixation (15c₁, 15c₂) ;
- l'ensemble de plaques (3) est placé par son premier bord latéral (3₁) entre les deux languettes de fixation (15c₁, 15c₂), la première languette de fixation (15c₁) reposant sur la première couche extérieure (3b) et la deuxième languette de fixation (15c₂) reposant sur la deuxième couche extérieure (3c) ;
- le système de fixation (15) comprend au moins une ou au moins deux chevilles de fixation (15d), l'au moins une ou les au moins deux chevilles de fixation (15d) s'écoulant à travers les deux languettes de fixation (15c₁, 15c₂) et l'ensemble de plaques (3), suite à quoi, un retrait de l'ensemble de câbles (2) de l'ensemble de plaques (3) est empêché ; et/ou
entre la première languette de fixation (15c₁) et la première couche extérieure (3b) est conçu un premier loqueteau à bille et/ou
entre la deuxième languette de fixation (15c₂) et la deuxième couche extérieure (3c) est conçu un deuxième loqueteau à bille.

14. Raccord de connexion (1) selon l'une quelconque des revendications précédentes, **caractérisé par** les caractéristiques suivantes :
- le système de fixation (15) comprend au moins un listel séparateur (15a), qui s'écoule à partir du corps de base (14) dans la direction de l'ensemble de plaques (3) et qui se termine dans l'espace de logement de câbles (8) ;
- à cet effet, l'au moins un premier câble (2a) est flanqué de l'au moins un ou de deux listels séparateurs (15a) ;
- à cet effet, l'au moins un listel séparateur (15a) s'écoule approximativement à la parallèle de l'au moins un premier câble (2a).

15. Procédé, destiné à fabriquer raccord de connexion (1) entre un ensemble de plaques (3) et un ensemble de câbles (2), présentant les étapes de procédé suivantes, consistant à :
- fabriquer (S₁) un ensemble de plaques (3), qui comprend au moins trois couches (3a, 3b, 3c) empilées les unes sur les autres dans la direction longitudinale (6), une couche intermédiaire (3a) diélectrique étant placée entre une première couche extérieure (3b) et une deuxième couche extérieure (3c), la première couche extérieure (3b) et/ou la deuxième couche extérieure (3c) étant conductrice d'électricité, un évidement (7) étant ménagé entre la première couche extérieure (3b) et la deuxième couche extérieure (3c), suite à quoi, un espace de logement de câbles (8) est créé sur un premier bord latéral (3₁) de l'ensemble de plaques (3) ;
- ménager (S₂) au moins un premier orifice de contact d'un conducteur interne (9a) dans l'ensemble de plaques (3), celui-ci traversant la première couche extérieure (3b) et/ou la deuxième couche extérieure (3c) et débouchant dans l'espace de logement de câbles (8) ;
- dénuder (S₃) le conducteur interne (4a) de l'au moins un premier câble (2a) de l'ensemble de câbles (2) ;
- utiliser un système de collecte et d'alignement des câbles (13), qui est constitué d'une matière plastique ou en comprend une telle et qui comprend par ailleurs un corps de base (14) et un système de fixation (15) qui est conçu sur le corps de base (14) ;
- placer de manière indéplaçable le système de collecte et d'alignement des câbles (13) sur l'au moins un premier câble (2a) ;
- appliquer (S₄) au moins un premier dépôt de brasure de conducteur interne (12a) dans l'au moins un premier orifice de contact d'un conducteur interne (9a) et/ou sur le conducteur interne (4a) dénudé de l'au moins un premier câble (2a) de l'ensemble de câbles (2) ;
- insérer (S₅) le conducteur interne (4a) de l'au moins un premier câble (2a) sur le premier bord latéral (3₁) dans l'espace de logement de câbles (8), de telle sorte que le conducteur interne (4a) de l'au moins un premier câble (2a) soit placé en décalage dans la direction longitudinale (6) par rapport à l'au moins un premier orifice de contact d'un conducteur interne (9a), le système de fixation (15) étant conçu pour fixer le système de collecte et d'alignement des câbles (13) sur l'ensemble de plaques (3), de telle sorte que l'au moins un premier câble (2a) de l'ensemble de câbles (2) soit placé de manière indéplaçable dans l'espace de logement de câbles (8) ; et
- faire chauffer (S₆) l'au moins un premier dépôt de brasure de conducteur interne (12a) jusqu'à ce qu'il soit en fusion et assemble de manière conductrice d'électricité le conducteur interne (4a) de l'au moins un premier câble (2a) par l'intermédiaire d'un premier assemblage par brasage de conducteur interne (16a), au moins dans la zone du premier orifice de contact d'un conducteur interne (9a) avec une première zone de connexion de conducteur interne (9a₁) de la première et/ou deuxième couche extérieure (3b, 3c).
